(19) Europäisches Patentamt / European Patent Office / Office européen des brevets

(11) **EP 3 531 420 B1**

(12) **FASCICULE DE BREVET EUROPEEN**

(45) Date de publication et mention
de la délivrance du brevet:
**15.11.2023 Bulletin 2023/46**

(21) Numéro de dépôt: **19158942.3**

(22) Date de dépôt: **22.02.2019**

(51) Classification Internationale des Brevets (IPC):
**G11C 11/16** $^{(2006.01)}$   **G11C 14/00** $^{(2006.01)}$
**H10N 50/01** $^{(2023.01)}$   **H10N 50/10** $^{(2023.01)}$

(52) Classification Coopérative des Brevets (CPC):
**G11C 11/161; G11C 14/0081; H10N 50/01;
H10N 50/10**

(54) **JONCTION TUNNEL MAGNETIQUE A ANISOTROPIE DE FORME PERPENDICULAIRE ET VARIABILITE MINIMISEE, POINT MEMOIRE ET ELEMENT LOGIQUE COMPRENANT LA JONCTION TUNNEL MAGNETIQUE, PROCEDE DE FABRICATION DE LA JONCTION TUNNEL MAGNETIQUE**

MAGNETISCHER TUNNELÜBERGANG MIT SENKRECHTER ANISOTROPIE UND MINIMIERTER VARIABILITÄT, SPEICHERPUNKT UND LOGIKELEMENT, DIE DEN MAGNETISCHEN TUNNELÜBERGANG UMFASSEN, UND HERSTELLUNGSVERFAHREN DES MAGNETISCHEN TUNNELÜBERGANGS

MAGNETIC TUNNEL JUNCTION WITH PERPENDICULAR ANISOTROPY AND MINIMISED VARIABILITY, MEMORY POINT AND LOGIC ELEMENT COMPRISING THE MAGNETIC TUNNEL JUNCTION, METHOD FOR MANUFACTURING THE MAGNETIC TUNNEL JUNCTION

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **23.02.2018 FR 1851603**

(43) Date de publication de la demande:
**28.08.2019 Bulletin 2019/35**

(73) Titulaires:
• **Commissariat à l'Energie Atomique et aux
Energies
Alternatives
75015 Paris (FR)**
• **Centre National de la Recherche Scientifique -
CNRS
75016 Paris (FR)**
• **Institut Polytechnique de Grenoble
38000 Grenoble (FR)**

(72) Inventeurs:
• **PERRISSIN-FABERT, Nicolas
38054 GRENOBLE (FR)**
• **DIENY, Bernard
38054 GRENOBLE (FR)**
• **PREJBEANU, Lucian
38054 GRENOBLE (FR)**
• **SOUSA, Ricardo
38054 GRENOBLE (FR)**

(74) Mandataire: **Lebkiri, Alexandre
Cabinet Camus Lebkiri
25, Rue de Maubeuge
75009 Paris (FR)**

(56) Documents cités:
**US-A1- 2013 177 781     US-A1- 2016 233 416
US-A1- 2017 316 813**

• **K. WATANABE ET AL: "Shape anisotropy
revisited in single-digit nanometer magnetic
tunnel junctions", NATURE COMMUNICATIONS,
vol. 9, no. 1, 14 février 2018 (2018-02-14),
XP055513325, DOI: 10.1038/s41467-018-03003-7**
• **WATANABE: "Supplementary Notes Shape
anisotropy revisited in single-digit nanometer
magnetic tunnel junctions", NATURE
COMMUNICATIONS, 14 février 2018 (2018-02-14),
XP055513682,**
• **SHUNSUKE FUKAMI ET AL: "Magnetization
switching by spin-orbit torque in an
antiferromagnet-ferromagnet bilayer system",
NATURE MATERIALS, vol. 15, no. 5, 1 mai 2016
(2016-05-01), pages 535-541, XP055513638, GB
ISSN: 1476-1122, DOI: 10.1038/nmat4566**

- PERRISSIN N ET AL: "Spin transfer torque magnetic random-access memory: Towards sub-10 nm devices", 2018 INTERNATIONAL CONFERENCE ON IC DESIGN & TECHNOLOGY (ICICDT), IEEE, 4 juin 2018 (2018-06-04), - 6 juin 2018 (2018-06-06), pages 125-128, XP033368032, DOI: 10.1109/ICICDT.2018.8399772
- N. PERRISSIN ET AL: "A highly thermally stable sub-20 nm magnetic random-access memory based on perpendicular shape anisotropy", NANOSCALE, vol. 10, no. 25, 18 mai 2018 (2018-05-18), pages 12187-12195, XP055513314, United Kingdom ISSN: 2040-3364, DOI: 10.1039/C8NR01365A
- NGUYEN V D ET AL: "Towards high density STT-MRAM at sub-20nm nodes", 2018 INTERNATIONAL SYMPOSIUM ON VLSI TECHNOLOGY, SYSTEMS AND APPLICATION (VLSI-TSA), IEEE, 16 avril 2018 (2018-04-16), pages 1-2, XP033369507, DOI: 10.1109/VLSI-TSA.2018.8403867
- ZEINALI BEHZAD ET AL: "Ultra-Fast SOT-MRAM Cell with STT Current for Deterministic Switching", 2017 IEEE INTERNATIONAL CONFERENCE ON COMPUTER DESIGN (ICCD), IEEE, 5 November 2017 (2017-11-05), pages 463-468, XP033262781, ISSN: 1063-6404, DOI: 10.1109/ICCD.2017.81 [retrieved on 2017-11-22]

**Description**

**DOMAINE TECHNIQUE DE L'INVENTION**

La présente invention concerne un dispositif magnétique comprenant une couche d'aimantation variable présentant une anisotropie magnétique perpendiculaire au plan des couches principalement induite par la forme de la couche d'aimantation variable. Un premier objet de l'invention est un procédé de fabrication d'une jonction tunnel magnétique. La variabilité de point à point des propriétés magnétiques et électriques des jonctions est minimisée en optimisant l'épaisseur et l'aimantation de la couche de stockage en fonction de la taille du point mémoire. Cette jonction tunnel magnétique trouve notamment une application dans le domaine de la spintronique en particulier pour la réalisation de mémoires magnétiques à accès aléatoire (ou « Magnetic Random Access Memory », MRAM en anglais) fonctionnant sur une large gamme de température notamment pour l'automobile, les applications industrielles, le domaine spatial mais aussi pour l'électronique grand public, le calcul haute performance, l'internet des objets.

**ETAT DE L'ART**

Afin de répondre aux récurrents besoins d'augmentation de la densité des mémoires pour l'électronique CMOS, la taille des dispositifs ne cesse de décroître. Cependant, les mémoires les plus couramment utilisées comme mémoires de travail (« Dynamic Random Access Memory », DRAM et « Static Random Access Memory », SRAM) sont volatiles c'est-à-dire qu'elles doivent continuellement être alimentées en tension pour conserver l'information. Elles ont de plus en plus de problèmes de consommation d'énergie, notamment en mode statique, en raison d'un courant de fuite accru lié à leur diminution en taille. Les mémoires FLASH utilisées pour le stockage de données ou de codes sont non volatiles, c'est-à-dire qu'elles conservent leurs données en l'absence d'alimentation, mais ont une endurance à l'écriture limitée à au plus 100 000 cycles et leur réalisation en version embarquée est complexe, nécessitant de 15 à 20 niveaux de masques.

Différentes technologies de mémoires non volatiles denses, endurantes à l'écriture et plus faciles à intégrer en technologie CMOS que les mémoires FLASH embarquées, sont en développement. Elles sont très intéressantes afin de diminuer la consommation d'énergie. Parmi les différentes technologies de mémoires non-volatiles (mémoire à changement de phase, mémoire à oxyde résistif, mémoire ferroélectrique etc), les mémoires magnétiques à accès aléatoire (« magnetic random access memory » en langue anglaise, MRAM) combinent un ensemble unique d'avantages : outre leur non-volatilité, elles sont rapides à l'écriture (~20ns), rapides à la lecture (quelques ns), peuvent être réalisées de façon dense (s'approchant de la densité des DRAMs), et présentent une endurance à l'écriture très supérieure à celle des mémoires FLASH (>$10^{10}$ cycles pour les MRAMs à comparer à <$10^5$ cycles pour les FLASH). Elles sont donc particulièrement intéressantes pour être intégrées dans les circuits électroniques. Ce type de mémoire est basé sur des jonctions tunnel magnétiques, formées par deux couches ferromagnétiques séparées par un oxyde isolant, généralement de l'oxyde de magnésium MgO. La résistance du dispositif varie typiquement d'un facteur compris entre 3 et 4 selon que l'aimantation des deux couches ferromagnétiques est parallèle ou antiparallèle, fournissant ainsi un « 0 » ou un « 1 » numérique. Dans un circuit électronique, la non-volatilité permet de réduire la consommation d'énergie en éteignant les parties temporairement inactives du circuit et donc en éliminant le courant de fuite dans ces parties. De nouvelles stratégies de coupure et déclenchement de l'alimentation (power gating en anglais) sont ainsi rendues possibles. Le concept de calcul électronique dans un circuit normalement éteint avec mise en marche instantanée (« Normally-Off/Instant-On computing » en langue anglaise) a même été introduit pour décrire cette approche (« Challenges toward gigabit-scale spin-transfer torque random access memory and beyond for normally off, green information technology infrastructure », Takayuki Kawahara, J. Appl. Phys. 109, 07D325, 2011).

Différentes familles de mémoires magnétiques ont été développées au cours des 20 dernières années. Elles diffèrent essentiellement par la façon dont l'information est écrite dans les points mémoires. Ecrire dans une mémoire MRAM revient à orienter l'aimantation d'une des électrodes magnétiques de la jonction tunnel (électrode appelée couche de stockage) parallèlement ou antiparallèlement à l'aimantation de la deuxième électrode d'aimantation fixe appelée couche de référence. Dans la première famille de MRAMs, l'écriture était faite par impulsions de champs magnétiques. Des produits commerciaux de la société EVERSPIN™ appelés Toggle MRAM ont utilisé ce procédé d'écriture à partir de 2006. Cependant, la densité de ces mémoires est limitée à quelques Mbit car le courant nécessaire pour produire les impusions de champs magnétiques (~10mA), ne permet pas de descendre à des noeuds technologiques inférieurs à 90nm.

La deuxième famille de MRAM qui retient aujourd'hui le plus d'attention est la famille des MRAMs écrites par transfert de spin (« spin transfer torque », STT en langue anglaise). Il s'agit des STT-MRAM. Le phénomène de transfert de spin a été prédit en 1996 par Sionczewski (Slonczewski, J. C., 1996, "Current driven excitations of magnetic multilayers," J. Magn. Magn. Mater.159, L1-L7) et Berger (Berger, L., 1996, "Emission of spin waves by a magnetic multilayer traversed by a current", Phys. Rev. B 54, 4828-4830) et la possibilité d'utiliser ce phénomène pour faire commuter l'aimantation de couches magnétiques a été démontré expérimentalement pour la première fois en 2000 (Katine, J.A., F. J. Albert, R. A. Buhrman, E. B. Myers, and D. C. Ralph, 2000, "Current-driven magnetization reversai and spin-wave excitations in Co /Cu /Co pillars," Phys. Rev. Lett.84, 3149-3152).

L'utilisation du transfert de spin pour écrire dans une jonction tunnel magnétique fournit une meilleure configuration, en particulier lorsque la densité est importante, c'est-à-dire lorsque la mémoire est de petite taille (typiquement inférieure à 50 nm de diamètre).

Deux paramètres sont très importants pour décrire les performances d'une STT-MRAM. Le premier est le facteur de stabilité thermique $\Delta = E_b/K_B T$. Dans cette expression, $E_b$ représente la barrière d'énergie séparant les deux états stables de l'aimantation de la couche de stockage, c'est-à-dire la barrière d'énergie qu'il faut franchir pour faire commuter l'aimantation de la couche de stockage de parallèle à antiparallèle à celle de la couche de référence ou réciproquement d'antiparallèle à parallèle suivant la valeur que l'on veut écrire dans le point mémoire (« 0 » ou « 1 »). Cette barrière d'énergie est liée à l'anisotropie magnétique de la couche de stockage. Ce paramètre est très important car il détermine la durée de rétention de la mémoire, c'est-à-dire combien de temps la mémoire arrive à conserver l'information que l'on a écrit avant que des fluctuations thermiques ne viennent effacer cette information. Il permet aussi d'estimer le taux d'erreur au repos (en standby) ou lors de la lecture en fonction du temps et de la capacité de la mémoire. Comme il est connu de l'homme de l'art, pour des mémoires de capacité de l'ordre de 1Gbit, des facteurs de stabilité thermique de l'ordre de 80 sont nécessaires mais la valeur exacte du $\Delta$ requis dépend du taux d'erreur que l'on tolère (B.Dieny, L.Prejbeanu, chapter Magnetic Random Access Memory, in Introduction to Magnetic Random Access Memory, edited by B.Dieny, R.B.Goldfarb, K.J.Lee, IEEE Press, J.Wiley). Les premières STT-MRAMs qui ont été développées présentent une aimantation planaire, c'est-à-dire que les aimantations de la couche de stockage et de la couche de référence sont orientées au repos dans le plan des couches. L'anisotropie de la couche de stockage est alors le plus souvent obtenue en donnant à la jonction tunnel magnétique une forme allongée dans le plan, en particulier une forme elliptique caractérisée par un grand axe typiquement 2 à 3 fois plus grand que le petit axe de l'ellipse. A ce moment-là, l'aimantation a tendance à s'aligner avec le grand axe de l'ellipse qui constitue l'axe facile d'aimantation, le petit axe étant à contrario l'axe difficile d'aimantation. La hauteur de barrière d'énergie $E_b$ pour faire passer l'aimantation de la couche de stockage d'un sens au sens opposé par rotation cohérente est donnée par l'expression approchée suivante (Apalkov, D., B. Dieny and J. M. Slaughter, Magnetoresistive Random Access Memory, Proceedings of the IEEE 104 (2016) 1796-1830) :

$$E_b = \mu_0 \pi^2 (M_s L)^2 w (AR - 1)$$

où $\mu_0$ est la permittivité du vide, $M_s$ l'aimantation de la couche de stockage, L l'épaisseur de la couche de stockage, w la largeur de l'ellipse (dimension du petit axe), $AR$ le rapport d'aspect de l'ellipse c'est-à-dire le rapport de la longueur du grand axe divisé par la longueur du petit axe. Dans ces MRAMs à aimantation planaire, le rapport d'aspect est en général limité à 3 au maximum car au-delà, le renversement de l'aimantation ne se produit plus par rotation cohérente de l'aimantation mais par nucléation et propagation de parois. La hauteur de barrière n'augmente alors plus avec le rapport d'aspect voire diminue pour une surface totale du point mémoire donnée.

Plus récemment, comme il va être expliqué plus loin, l'intérêt pour les STT-MRAMs s'est concentré sur les jonctions tunnel magnétiques à aimantation perpendiculaire. Ceci est dû à deux raisons principales. D'une part, on arrive à créer des anisotropies beaucoup plus fortes en anisotropie perpendiculaire qu'en anisotropie planaire, notamment en jouant sur des phénomènes d'anisotropie interfaciale. Ceci permet de diminuer la taille des points mémoires tout en gardant un facteur de stabilité thermique suffisant. D'autre part, pour un même facteur de stabilité thermique donné, c'est-à-dire pour une durée de rétention donnée, il est connu que le courant critique de commutation est beaucoup plus faible pour les jonctions à aimantation perpendiculaire que pour les jonctions à aimantation planaire. Ceci sera expliqué plus en détails plus loin.

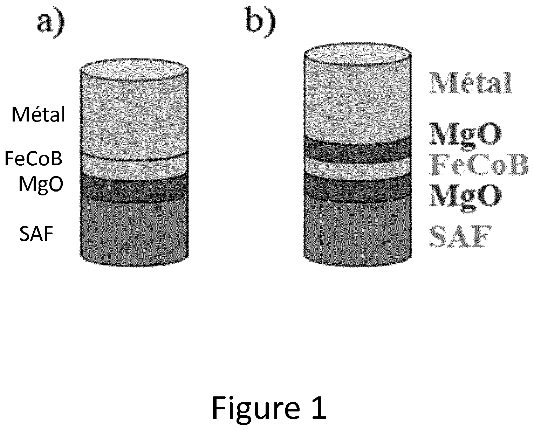

Les STT-MRAMs de l'état de l'art reposent sur un phénomène d'anisotropie perpendiculaire aux interfaces métal magnétique/oxyde (US8,247,093(B2), US 8,513,944(B2)). Ce phénomène a été observé avec différents oxydes (AIOx, MgO, TaOx, CrOx) et différents matériaux magnétiques (Co, Fe et alliages) mais est particulièrement intéressant dans le contexte des STT-MRAMs aux interfaces CoFeB/MgO (Ikeda, S., K. Miura, H. Yamamoto, K. Mizunuma, H. D. Gan, M. Endo, S. Kanai, J. Hayakawa, F. Matsukura, and H. Ohno, 2010, "A perpendicular-anisotropy CoFeB-MgO magnetic tunnel junction," Nature Mater. 9, 721-724). Cette anisotropie interfaciale est souvent notée $K_s$. C'est une énergie par unité de surface qui peut être de l'ordre de 1 à 2 mJ/m$^2$ à l'interface CoFeB/MgO. Il a été montré que cette anisotropie est plus élevée à l'interface Fe/MgO qu'elle ne l'est à l'interface Co/MgO (Yang, H. X., M. Chshiev, B. Dieny, J. H. Lee, A. Manchon, and K. H. Shin, 2011, "First principles investigation of the very large perpendicular magnetic anisotropy at Fe|MgO and Co|MgO interfaces," Phys. Rev. B 84, 054401). Cette anisotropie perpendiculaire interfaciale suffit dans les STT-MRAMs conventionnelles à tirer l'aimantation de la couche de stockage hors du plan en dépassant l'anisotropie de forme qui a plutôt tendance à rabattre l'aimantation dans le plan dans la mesure où l'épaisseur de la couche de stockage est très inférieure à son diamètre dans les STT-MRAMs de l'état de l'art. Ainsi une jonction tunnel de l'état de l'art à anisotropie perpendiculaire est décrite sur la Figure 1a. Elle comprend en général une couche de référence d'aimantation fixe généralement constituée d'un antiferromagnétique synthétique (SAF) bien connu de l'homme de l'art, une barrière tunnel en MgO, une couche de stockage en alliage à base de Co, de Fe et de B, et une couche de protection métallique non-magnétique, souvent en tantale ou en tungstène ou molybdène.

Afin d'augmenter encore l'anisotropie interfaciale de la couche de stockage, il a aussi été proposé d'insérer la couche de stockage entre deux barrières d'oxyde comme décrit sur la Figure 1b. Ceci permet de bénéficier des deux interfaces entre l'une et l'autre des barrières d'oxyde et la couche magnétique de stockage (US8,247,093(B2) ; US 8,513,944(B2) ; Sato, H., T. Yamamoto, M. Yamanouchi, S. Ikeda, S. Fukami, K. Kinoshita, F. Matsukura, N. Kasai, and H. Ohno, 2014, "Comprehensive study of CoFeB-MgO magnetic tunnel junction characteristics with single- and double-interface scaling down to 1X nm," in Proceedings of the International Electron Devices Meeting (IEDM), San Francisco, 33.2.1-33.2.4).

Dans les jonctions tunnel à aimantation perpendiculaire dans laquelle la couche de stockage a une forme généralement de cylindre aplati (c'est-à-dire ayant une épaisseur très inférieure au diamètre), la barrière d'énergie séparant les deux états d'aimantation de la couche de stockage (aimantation « vers le haut » ou aimantation « vers le bas) est donnée par :

$$E_b = A \left[ K_{s1} + K_{s2} - \frac{\mu_0}{2}(N_{xx} - N_{zz})M_s^2 L + K_u L \right]$$

Dans cette expression, A représente la surface (aire) de la couche de stockage, $K_{s1}$ et $K_{s2}$ représentent les anisotropies interfaciales aux deux interfaces inférieure et supérieure de la couche de stockage, $N_{xx}$ et $N_{zz}$ sont les coefficients de champ démagnétisant suivant la direction x dans le plan et z hors du plan, $\mu_0$, $M_s$ et $t$ ont été définis précédemment, $K_u$ est une éventuelle anisotropie de volume par exemple d'origine magnétocrystalline ou magnétoélastique. En général, cette énergie est négligeable par rapport aux autres contributions à l'anisotropie pour les matériaux communément utilisés dans les STT-MRAMs. En ce qui concerne $N_{xx}$ et $N_{zz}$, tant que l'épaisseur de la couche est très inférieure à son diamètre, on a $N_{xx} \sim 0$ et $N_{zz} \sim 1$. Lorsque l'épaisseur n'est plus très inférieure à la dimension latérale, une expression approchée de $N_{xx}$-$N_{zz}$ est (M. Sato and Y. Ishii, J. Appl. Phys. 60, 983 (1989)) :

$N_{xx} - N_{zz} = \frac{1}{2}\left( 1 - \frac{3}{1+2f\,AR} \right)$, où $f$ = 1 dans le cas d'un parallélépipède rectangle à base carrée et $f = \frac{2}{\sqrt{\pi}}$ dans le cas d'un cylindre à base circulaire. Cette expression approchée est utile pour développer un calcul analytique mais des valeurs plus précises sont données dans la publication suivante : Du-Xing Chen, James A. Brug, Member, IEEE, and Ronald B. Goldfarb, Demagnetizing Factors for Cylinders, IEEE Trans.Mag. 4, 3601 (1991) ou dans la suivante pour des cylindres à section elliptique : M Beleggia, M De Graef, Y T Millev, D A Goode and G Rowlands, Demagnetization factors for elliptic cylinders, J. Phys. D: Appl. Phys. 38 (2005) 3333.

Rappelons que par convention, en magnétisme, lorsqu'une anisotropie est positive, elle tend à orienter l'aimantation hors du plan de la couche. Au contraire, lorsque l'anisotropie est négative, elle tend à orienter l'aimantation dans le plan.

Dans les STT-MRAM à anisotropie perpendiculaire de l'état de l'art, le terme d'anisotropie interfaciale $A(K_{s1}$

$$A\left[ \frac{\mu_0}{2}\left(N_{xx} - N_{zz}\right)M_s^2 L \right]$$

+ $K_{s2}$) est positif tandis que le terme - lié à l'anisotropie de forme de la couche de stockage est négatif de sorte que les deux termes sont en compétition. Ceci est problématique dans les STT-MRAMs de l'état de l'art car empêche d'augmenter l'épaisseur t de la couche de stockage. En effet, en augmentant cette épaisseur, on augmente le poids relatif de l'anisotropie de forme planaire par rapport à l'anisotropie interfaciale perpendiculaire ce qui réduit l'anisotropie totale effective. C'est pour cela que dans les STT-MRAMs perpendiculaires conventionnelles, l'épaisseur de la couche de stockage est limitée à des valeurs de l'ordre de 1.4nm pour les jonctions à simple barrière tunnel et à environ 2nm pour les jonctions à double barrière.

Un autre problème des mémoires MRAM de l'état de l'art à aimantation hors du plan est que la hauteur de barrière est proportionnelle à la surface de la jonction tunnel. Plus on avance vers des noeuds technologiques de plus en plus petits, plus cette surface A diminue. En conséquence $E_b$ diminue et il y a toujours un seuil de diamètre en dessous duquel le facteur de stabilité thermique devient trop petit pour assurer une rétention suffisante et donc un taux d'erreur suffisamment faible dans la conservation des données écrites dans la mémoire. Typiquement, avec les mémoires de l'état de l'art, le diamètre critique en dessous duquel la hauteur de barrière d'énergie devient trop faible à 85°C se situe autour de 25nm.

Un deuxième paramètre très important pour caractériser un point mémoire STT-MRAM est son courant d'écriture $I_{c0}$. Il est connu de l'homme de l'art que le courant d'écriture dans une STT-MRAM dépend de la durée des impulsions de courant d'écriture. Dans le régime dit activé thermiquement observé pour des impulsions de durée typiquement

$$I_c = I_{c0}\left\{1 - \frac{k_B T}{E_b} Ln\left(\frac{\tau}{\tau_0}\right)\right\}$$

où $\tau$ est la durée de l'impulsion et $\tau_0$ un temps d'essai caractéristique de l'ordre de 1ns. Le courant d'écriture varie donc linéairement en fonction du Logarithme de la durée des impulsions. $I_{c0}$ correspond à l'extrapolation de ce comportement linéaire pour une durée d'impulsion de 1ns.

$I_{c0}$ est un paramètre très important car il détermine la taille du transistor de sélection connecté à la jonction tunnel. Pour une résistance donnée du point mémoire, laquelle est en général ajustée pour être de l'ordre de grandeur de celle du transistor en mode passant, ce courant d'écriture va déterminer la tension d'écriture. Le produit résistance*surface (RA) de la jonction tunnel est en général ajusté en jouant sur l'épaisseur de la barrière tunnel pour que cette tension se situe autour de 0.3 à 0.5V, suffisamment basse par rapport à la tension de claquage diélectrique de la barrière tunnel (~1.2 à 1.6V) pour assurer une endurance à l'écriture quasi illimitée du point mémoire. Par ailleurs le courant d'écriture influe sur la consommation électrique que l'on cherche la plupart du temps à minimiser surtout pour les applications nomades ou les dispositifs de l'internet des objets.

Du point de vue théorique, le courant d'écriture est donné par les expressions suivantes (Sun, J. Z, 2000, "Spincurrent interaction with a monodomain magnetic body: A model study," Phys. Rev. B 62, 570-578.) :

- Pour les STT-MRAMs à aimantation planaire :

$$I_c^0 = A j_c^0 = \frac{A}{\eta}\frac{2\alpha e \mu_0}{\bar{h}}(M_S L)\left(\frac{H_\perp^{eff}}{2} + H_K\right)$$

dans lequel A est l'aire de la jonction, $j_c^0$ est la densité de courant critique pour écrire, $\eta$ est l'efficacité du couple de transfert de spin liée à la polarisation en spin du courant injecté dans la couche de stockage au moment de l'écriture (typiquement ~80% pour des barrières de MgO de l'état de l'art), $\bar{h}$ est la constante de Planck réduite, e la valeur absolue de la charge de l'électron, $\alpha$ est l'amortissement de Gilbert du matériau constitutif de la couche de stockage, $M_s$ son aimantation, L l'épaisseur de la couche stockage, e la charge de l'électron, $\mu_0$ la permittivité du vide, $H_\perp^{eff}$ le champ démagnétisant effectif ressenti par l'aimantation de la couche de stockage si elle pointe hors du plan, ce champ

$$\mu_0 H_\perp^{eff} = \mu_0 M_s - 2\left(\frac{K_s}{L} + K_u\right)$$

étant donné par et $H_K$ est le champ d'anisotropie planaire qui définit la rétention de la mémoire, $H_K$ étant donné par $\mu_0 M_s H_K = E_b = \mu_0 \pi^2 (M_S L)^2 w(AR - 1)$. Comme il est connu de l'homme de l'art, dans le cas des jonctions tunnel magnétiques, la barrière d'énergie à franchir pour faire commuter l'aimantation par STT (proportionnelle à ($\frac{H_\perp^{eff}}{2} + H_K$)) est bien plus élevée celle qui détermine la rétention de la mémoire (proportionnelle à ($H_K$)). Ceci est défavorable car signifie que pour une rétention de la mémoire donnée, il faut fournir plus de courant pour vaincre la barrière plus élevée associée à la commutation que nécessaire de par la rétention de la mémoire. Ce coût additionnel en courant lors de la commutation provient du fait que dans sa dynamique de commutation par STT, l'aimantation est forcée à sortir du plan de la couche, ce qui coûte beaucoup d'énergie additionnelle.

- Pour les STT-MRAMs à aimantation perpendiculaire :

$$I_c^0 = A j_c^0 = \frac{A}{\eta}\frac{2\alpha e \mu_0}{\bar{h}}(M_S L)\left(H_K^{eff}\right)$$

où les notations sont les mêmes que ci-dessus et $H_K^{eff}$ représente le champ d'anisotropie perpendiculaire effectif ressenti par l'aimantation de la couche de stockage donné par :

$$\mu_0 H_K^{eff} = \mu_0 (N_{xx} - N_{zz}) M_s + \frac{2}{M_s}\left(\frac{K_{s1} + K_{s2}}{L} + K_u\right)$$

Dans les STT-MRAMs de l'état de l'art, ce champ d'anisotropie perpendiculaire effectif est essentiellement dû à l'anisotropie interfaciale aux interfaces entre la couche de stockage et les deux couches adjacentes qui sont, le plus souvent, deux couches d'oxydes en MgO. Ce champ d'anisotropie est réduit par le champ démagnétisant exprimé par le terme $\mu_0(N_{xx} - N_{zz})M_s$ opposé au terme de champ d'anisotropie lié aux interfaces. Le terme en $K_u$ correspond à l'existence éventuelle d'une anisotropie de volume d'origine magnétocrystalline ou magnétoélastique en général négligeable.

En combinant les deux expressions ci-dessus avec celle donnée précédemment pour la hauteur de barrière $E_b$ en anisotropie perpendiculaire, on déduit :

$$I_c^0 = \left(\frac{4e}{\hbar}\right)\frac{\alpha E_b}{\eta}$$

Cette relation, valable dès que l'aimantation se comporte de façon macrospin, c'est-à-dire comme un bloc d'aimantation uniforme, montre que le courant d'écriture est directement proportionnel à la barrière $E_b$ qui détermine la rétention de la mémoire. Ceci est beaucoup plus favorable que pour les jonctions tunnel planaires pour lesquelles un surcoût en courant d'écriture était nécessaire pour réaliser la commutation de l'aimantation de la couche de stockage. Ceci explique l'intérêt supérieur des jonctions tunnel à aimantation hors du plan pour les STT-MRAMs comparativement aux jonctions à aimantation planaire. Toutefois dans l'état de l'art, il est connu que l'amortissement de Gilbert $\alpha$ augmente pour les couches très minces à cause de phénomènes de pompage de spin (spin-pumping) (Ikeda, S., K. Miura, H. Yamamoto, K. Mizunuma, H. D. Gan, M. Endo, S. Kanai, J. Hayakawa, F. Matsukura, and H. Ohno, 2010, "A perpendicular-anisotropy CoFeB-MgO magnetic tunnel junction," Nature Mater. 9, 721-724). Ceci augmente d'autant le courant d'écriture qui lui est proportionnel.

Pour résumer, les jonctions tunnels magnétique de l'état de l'art et les points mémoire qui les utilisent ne permettent pas de :

- Arriver à conserver un facteur de stabilité thermique suffisamment grand dans des jonctions tunnels dont le diamètre correspond aux noeuds technologiques les plus avancés (de 40nm jusqu'à 4nm), et donc assurer une rétention suffisamment longue dans ces jonctions tunnel ;
- Minimiser le courant d'écriture ;
- Réduire les variations d'anisotropie et de courant d'écriture sur une large gamme de température d'opération, par exemple -40°C à +150°C pour les applications automobiles.

Le document "Shape anisotropy revisited in single-digit nanometer magnetic tunnel junctions", K. WatanabeB. JinnaiS. FukamiH. SatoH. Ohno, 2018, Nature Communications, Vol 9:663, doi:10.1038/ s41467-018-03003-7, divulgue un procédé de fabrication d'une jonction tunnel magnétique à aimantation hors du plan comprenant une couche de stockage, FeB, ayant une aimantation commutable entre deux états d'aimantation normale au plan de la couche, les deux états d'aimantation de la couche de stockage étant séparés par une barrière d'énergie, ladite couche de stockage présentant une épaisseur de 15nm comprise entre 0.5 fois et 8 fois un diamètre D de 10 nm d'une section planaire circulaire de la jonction tunnel, la section planaire étant une section de la jonction tunnel selon le plan des couches formant la jonction tunnel, ladite jonction tunnel magnétique possédant un facteur de stabilité thermique Δ dépendant de la barrière d'énergie et de la température moyenne d'utilisation de la jonction tunnel magnétique, ledit procédé étant caractérisé en ce qu'il comprend les étapes de : choix d'un matériau composant la couche de stockage possédant une épaisseur de 15 nm de la couche de stockage tel que la valeur absolue de la dérivée du facteur de stabilité thermique par rapport au diamètre de la section planaire de la jonction tunnel soit inférieure à 10 nm-1, la dérivée du facteur de stabilité thermique étant calculée à une température Tm , la température Tm étant la température moyenne d'utilisation de la jonction; dépôt de l'ensemble des couches; gravure de la couche de stockage ; et gravure des autres couches.

## DESCRIPTION GENERALE DE L'INVENTION

Pour résoudre au moins partiellement ces problèmes techniques, un objet de la présente invention est un procédé de fabrication selon la revendication 1 d' une jonction tunnel magnétique à aimantation hors du plan

On entend par barrière d'énergie séparant les deux états d'aimantation de la couche de stockage la différence d'énergie entre le minimum d'énergie correspondant à l'état initial stable de l'aimantation de la couche de stockage et le maximum d'énergie rencontré au cours du retournement de l'aimantation vers son état final stable.

On entend par facteur de stabilité thermique une mesure de la stabilité de l'aimantation de la couche de stockage pour une barrière d'énergie et une température donnée.

Par exemple, le facteur de stabilité thermique peut être exprimé comme $\Delta=E_b/K_B T$, $E_b$ étant la barrière d'énergie, T la température et $K_B$ la constante de Boltzmann.

On entend par section planaire de la jonction tunnel une section de la jonction tunnel selon le plan des couches formant la jonction tunnel.

On entend par dimension caractéristique d'une section planaire une dimension de ladite section planaire. La jonction tunnel a une section circulaire et la dimension caractéristique d'une section planaire de la jonction tunnel est le diamètre du cercle. Selon une alternative non-revendiquée, en cas de section elliptique, la dimension caractéristique peut être choisie comme étant le petit axe ou le grand axe de l'ellipse.

Dans ce qui suit « dimension caractéristique d'une section planaire » et « dimension planaire caractéristique » sont synonymes.

On entend par choix de la composition de la couche de stockage le choix d'au moins un des matériaux compris dans la couche de stockage.

Si la jonction tunnel est utilisée à une température comprise entre les températures $T_1$ et $T_2$, la température moyenne d'utilisation $T_m$ est définie comme $T_m = (T_1 + T_2)/2$. Par exemple, dans le cas d'une application automobile pour laquelle la mémoire doit fonctionner entre -40°C et +150°C, $T_m$ vaudra 55°C soit 328K.

On entend par épaisseur de la couche de stockage la taille de la couche de stockage mesurée selon une direction normale au plan des couches.

Avantageusement, la jonction tunnel magnétique obtenue par le procédé de l' l'invention permet d'augmenter l'épaisseur de la couche de stockage. En effet, une couche de stockage plus épaisse présente moins de fluctuations thermiques à la température de fonctionnement et souffre moins d'éventuels problèmes d'interdiffusion que les couches de stockage de l'état de l'art. Grâce à l'invention, on obtient une amplitude de magnétorésistance plus élevée et une moindre dépendance des propriétés magnétiques et de transport sur la gamme de températures d'opération. En particulier, la jonction tunnel magnétique est particulièrement adaptée à des applications dans le domaine de l'électronique grand public (gamme de température comprise entre 0°C et 85 °C) et dans le domaine de l'automobile (gamme de température comprise entre -40 °C et 150 °C).

Avantageusement, l'augmentation de l'épaisseur de la couche de stockage permet l'utilisation de matériaux et d'épaisseurs ayant un plus faible amortissement de Gilbert et donc la minimisation du courant d'écriture.

Le principe de l'invention peut être expliqué de la façon suivante.

Dans l'état de l'art, hormis le document cité ci-dessus "Shape anisotropy revisited in single-digit nanometer magnetic tunnel junctions", les STT-MRAMs ont toujours utilisé des couches de stockage très minces dont l'épaisseur est bien inférieure au diamètre. Ceci était motivé en particulier par le fait que le transfert de spin étant un phénomène interfacial (se produisant typiquement sur le premier nanomètre à partir de l'interface par où le courant polarisé en spin est injecté), il est préférable d'utiliser des couches très minces pour ne pas diluer l'efficacité du couple de transfert de spin. Pour de telles couches très minces, l'anisotropie de forme favorise une orientation dans le plan de l'aimantation de la couche de stockage et s'oppose donc à l'anisotropie interfaciale qui, elle, favorise une orientation perpendiculaire de cette aimantation. Ceci conduit à une anisotropie effective d'amplitude relativement moyenne résultant de la compétition de ces deux termes d'anisotropie.

Le procédé de la présente invention propose de changer complètement de paradigme en obtenant une couche de stockage beaucoup plus épaisse c'est-à-dire dont l'épaisseur est d'au moins la moitié d'une dimension planaire caractéristique de la couche de stockage. Par dimension planaire caractéristique, on entend diamètre du un point mémoire de forme cylindrique à base ronde,

Ainsi l'anisotropie de forme est considérablement réduite voire même favorise aussi une orientation hors du plan de l'aimantation. Dans ce cas, l'anisotropie de forme et l'anisotropie d'interface peuvent s'ajouter, pour toutes les deux favoriser une orientation perpendiculaire au plan des couches de l'aimantation de la couche de stockage.

Nous nommerons les mémoires utilisant cette anisotropie de forme verticale PSA-MRAM pour « Perpendicular Shape Anisotropy-MRAM » selon la terminologie anglaise.

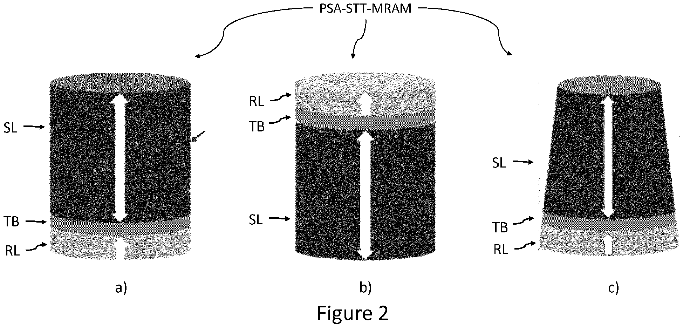

Dans ce qui suit il sera fait référence à des mémoires ayant une forme cylindrique mais l'homme de l'art comprendra que le présent brevet peut être facilement adapté au cas où la jonction tunnel et en particulier la couche de stockage aurait une forme légèrement pyramidale (illustrée sur la Figure 2c) notamment du fait du processus de gravure lorsque la gravure par faisceau d'ions est utilisée (Ion beam etching (IBE) suivant la terminologie anglaise). En effet, il est connu que si la gravure est réalisée par faisceau d'ions (IBE), les flancs du pilier peuvent être légèrement inclinés (tapered shape en anglais) à cause d'effets d'ombrage. L'anisotropie de forme peut s'en trouver quantitativement modifiée mais l'esprit du brevet reste le même.

Pour bien comprendre l'idée, nous utilisons ici le cas le plus courant d'une jonction tunnel dont la couche de stockage a une forme quasi cylindrique. Dans ce cas et en supposant que la couche de stockage est constituée d'un seul matériau d'aimantation $M_s$, la barrière d'énergie séparant les deux états d'aimantation « vers le haut » et « vers le bas » peut s'exprimer de façon approchée par :

$$E_b \approx A\left[K_{s1} + K_{s2} - \frac{\mu_0}{4}\left(1 - \frac{3}{1 + 4AR/\sqrt{\pi}}\right)M_s^2 L + K_u L\right]$$

Cette expression montre que dès que le rapport de forme de la couche de stockage dépasse $AR = \frac{\sqrt{\pi}}{2} \approx 0.89$ alors le terme d'anisotropie de forme $-\frac{\mu_0}{4}\left(1 - \frac{3}{1 + 4AR/\sqrt{\pi}}\right)M_s^2 L$ change de signe pour passer de négatif à positif. En d'autres termes, pour un rapport d'aspect épaisseur/diamètre plus grand que ~0.89, l'anisotropie de forme s'ajoute à l'anisotropie perpendiculaire d'interface présente à l'interface barrière tunnel/couche de stockage.

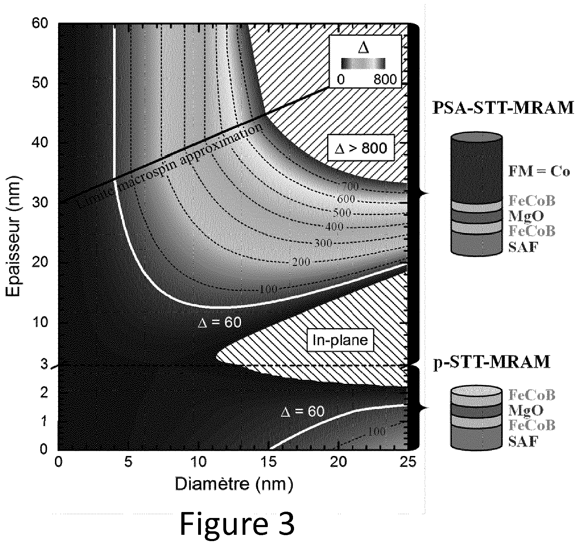

Ceci est illustré sur la Figure 3 qui représente le facteur de stabilité thermique Δ en code couleur en fonction du diamètre de la couche de stockage et de son épaisseur. Les paramètres choisis pour établir ce diagramme correspondent à une couche de stockage en cobalt. Les STT-MRAM de l'état de l'art, ou p-STT-MRAM, se trouvent dans le coin en bas à droite de ce diagramme. Comme discuté précédemment, dans cette situation de l'état de l'art, l'anisotropie effective et donc le facteur de stabilité thermique diminue si l'épaisseur de la couche augmente. Pour une épaisseur de la couche de stockage minimale de l'ordre de 1.5nm pour avoir une magnétorésistance tunnel suffisante, le diagramme montre qu'on ne peut pas descendre en dessous d'un diamètre de l'ordre de 20nm en gardant un facteur de stabilité thermique supérieur à 60.

Par contre, si on passe dans le régime exploité par la présente invention où l'épaisseur de la couche de stockage devient beaucoup plus importante (partie supérieure du diagramme) alors de très fortes valeurs du facteur de stabilité thermique (Δ>60) peuvent être obtenues et ceci jusque des diamètres de l'ordre de 4nm.

Le diagramme fait apparaitre la ligne de limite de l'approximation macrospin. En dessous de cette limite, on peut considérer que l'aimantation de la couche de stockage se retourne de façon cohérente alors qu'au-dessus de cette ligne, le retournement de l'aimantation va plutôt se faire avec une déformation importante de l'aimantation pouvant comprendre la nucléation d'un domaine inverse et la propagation de la paroi magnétique séparant ce domaine inverse du reste de la couche.

Tant qu'on reste dans la région où l'approximation macrospin est valable, la relation

$$I_c^0 = \left(\frac{4e}{\hbar}\right)\frac{\alpha E_b}{\eta} = \left(\frac{4e}{\hbar}\right)\frac{\alpha k_B T \Delta}{\eta}$$

reste valable.

Ceci montre un résultat contrintuitif : bien qu'on augmente considérablement l'épaisseur de la couche de stockage par rapport aux STT-MRAM de l'état de l'art, hormis le document "Shape anisotropy revisited in single-digit nanometer magnetic tunnel junctions", le courant d'écriture ne sera pas augmenté tant qu'on reste dans la même gamme de valeurs du facteur de stabilité thermique Δ requis par les applications, c'est-à-dire typiquement Δ entre 60 et 100 suivant la capacité de la mémoire et le taux d'erreur tolérable.

Au contraire, le fait d'augmenter l'épaisseur de la couche de stockage a plusieurs avantages :

- Une couche épaisse possède des propriétés magnétiques beaucoup plus proches du matériau massif (bulk) qu'une couche très fine comme le sont les couches de stockage habituellement utilisées dans les p-STT-MRAMs de l'état de l'art (couches de 1.5nm à 2nm d'épaisseur). En particulier, les fluctuations thermiques se développent moins vite en fonction de la température que dans une couche très mince. En effet, il est connu que du fait du nombre réduit d'atomes voisins en surface d'une couche magnétique, la température d'ordre magnétique tend à s'abaisser dans les couches ferromagnétiques de quelques plans atomiques d'épaisseur. Ceci veut dire que les fluctuations thermiques se développent de façon plus importante dans les couches très minces que dans les matériaux massifs de même composition. Dans le contexte des p-STT-MRAMs de l'état de l'art, ceci se traduit par une décroissance rapide de la magnétorésistance tunnel et de l'anisotropie magnétique en fonction de la température, ce qui est gênant si le dispositif doit fonctionner sur une large gamme de températures (-40°C à +150°C pour l'automobile) ou doit arriver à garder la mémoire pendant une opération de soudure pouvant entrainer une élévation de température à 260°C pendant une minute (solder reflow compliance). Ainsi, comme le courant d'écriture est proportionnel à $E_b$, la forte variation d'anisotropie sur la gamme d'opération des STT-MRAMs conventionnelles conduit à une faible rétention à la limite supérieure de la gamme d'opération et à un fort courant d'écriture à la limite inférieure de la gamme d'opération. Grâce à l'utilisation de couches magnétiques épaisses comme proposé dans la présente invention, on diminue fortement cette variation thermique qui ressemble beaucoup plus à celle du matériau massif. Ainsi à titre d'exemple, le cobalt massif ne voit son aimantation varier que de quelques % (5 à 7%) entre - 40°C et 150°C alors qu'en couches d'épaisseur 1.5nm, cette variation peut être de 30 à 40%.

- Un second avantage concerne l'amortissement de Gilbert qui intervient directement dans le courant d'écriture. Tant qu'on reste dans le régime macrospin, l'amortissement de Gilbert α qui figure dans l'expression du courant d'écriture est l'amortissement de Gilbert moyenné sur tout le volume de la couche de stockage. Des optimisations sont alors possibles pour obtenir une forte magnétorésistance tunnel et un amortissement moyen faible comme expliqué ci-dessous.

Par ailleurs, un point important de la présente invention concerne l'optimisation du choix de l'épaisseur et des paramètres magnétiques de la couche de stockage pour minimiser les effets de dispersion des propriétés de point mémoire à point mémoire lors de la fabrication d'une puce mémoire. Parmi les paramètres suivants : diamètre, épaisseur, aimantation à saturation, anisotropie d'interface et anisotropie de volume, principalement le diamètre est susceptible de varier significativement de point mémoire à point mémoire du fait du procédé de gravure ou de nanostructuration des points mémoires. En effet, tous les autres paramètres sont choisis en amont de la gravure des jonctions et ne sont pas affectés par cette dernière. Les techniques de dépôt de l'homme de l'art sont parfaitement maitrisées et n'induisent pas de variations spatiales significatives de ses propriétés au sein d'une puce. En revanche, lors de la gravure des jonctions tunnels, il est inévitable que des variations de diamètre apparaissent d'une jonction à l'autre. Ces variations de diamètre peuvent typiquement être de l'ordre de 1 à quelques nanomètres. Puisque dans la présente invention l'anisotropie effective totale puise principalement ou intégralement sa source du terme d'anisotropie de forme, c'est-à-dire liée à la forme même de la couche de stockage, il est inévitable que des variations de diamètre induisent des variations de stabilité thermique, et par conséquent des variations de courant d'écriture. Afin de minimiser l'effet des variations de diamètre sur la stabilité, il est nécessaire de se placer au point défini par $min\left(\left|\frac{\partial \Delta}{\partial D}\right|\right)$ où $min(*)$ représente la fonction minimum et $|*|$ la fonction valeur absolue. En particulier, lorsque cela est possible, il est avantageux de se placer au point défini par $\frac{\partial \Delta}{\partial D} = 0$.

Le dispositif obtenu selon l'invention peut également présenter une ou plusieurs des caractéristiques ci-dessous, considérées individuellement ou selon toutes les combinaisons techniquement possibles :

- le diamètre de la jonction tunnel magnétique est inférieur à 50nm ;
- la couche de stockage est constituée d'un matériau magnétique homogène ;
- la couche de stockage comprend un ensemble de couches magnétiques et non magnétiques ;
- la couche de stockage comprend au moins une couche magnétique contenant un élément amorphisant tel que le bore et une ou plusieurs couches aptes à absorber l'élément amorphisant lors de recuit post-dépôt ;
- la couche de stockage comprend au moins deux matériaux magnétiques, dont un premier matériau proche de la barrière tunnel est apte à fournir une forte magnétorésistance tunnel et un deuxième matériau présente un faible amortissement de Gilbert ;
- la barrière tunnel est réalisée en MgO, AlOx, AlN, SrTiOs, HfOx ou tout autre oxyde ou nitride isolant ;
- la couche de stockage est constituée de l'empilement de différentes couches comprenant :

  ◦ une couche en alliage de cobalt, fer et bore d'épaisseur entre 1 et 4nm en contact avec la barrière tunnel ;
  ◦ une couche d'un matériau, apte à absorber le bore tel que Ta, Mo ou W au moment des recuits post-dépôt, d'épaisseur 0.2 à 0.4nm,
  o une couche magnétique à faible amortissement de Gilbert ;

- la jonction tunnel magnétique obtenue selon le procédé de l'invention possède avantageusement les propriétés suivantes :

  ◦ la couche de stockage présente une épaisseur comprise entre 0.8 et 8 fois une dimension caractéristique d'une section planaire de la jonction tunnel ;
  ◦ la contribution à la barrière d'énergie due à l'anisotropie de forme de la couche de stockage est au moins deux fois supérieure et de préférence au moins quatre fois supérieure aux contributions à la barrière d'énergie d'origine interfaciale.

La jonction tunnel magnétique obtenue selon le procédé de l'invention peut être utilisée dans une cellule MRAM à transfert de spin ou STT-MRAM ou point mémoire de type STT-MRAM ou dans une cellule MRAM à couple de spin orbite ou SOT-MRAM ou point mémoire de type SOT-MRAM ou dans une cellule MRAM à écriture par contrôle en tension des propriétés magnétiques de la couche de stockage ou VC-MRAM pour Voltage controlled MRAM, en d'autres termes, dans un point mémoire MRAM à écriture contrôlée en tension ou bien dans une cellule non-volatile intégrée dans un composant logique non-volatile.

## BREVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

- Figure 1a : Représentation schématique d'un empilement, non revendiqué, de p-STT-MRAM appartenant à l'état de l'art avec simple barrière de MgO et une électrode supérieure non-magnétique ;
- Figure 1b : Représentation schématique d'un empilement, non revendiqué, de p-STT-MRAM appartenant à l'état de l'art avec double barrière de MgO et une électrode supérieure non-magnétique ;
- Figure 2 : Représentation schématique de trois exemples, non revendiqués, d'une jonction tunnel magnétique PSA-STT-MRAM
- Figure 3 : Facteur de stabilité thermique (en niveaux de gris) en fonction du diamètre et de l'épaisseur de la couche de stockage ;
- Figure 4 : Représentation schématique de la jonction tunnel magnétique, PSA-MRAM-1 ;
- Figure 5 : Représentation schématique de la jonction tunnel PSA-MRAM-2;
- Figure 6 : Représentation de $\Delta$ en fonction du diamètre pour tout Ms (niveaux de gris) et pour différents épaisseurs L. Diagramme calculé à partir du modèle macrospin pour un cylindre avec $K_S = 0$ J/m$^2$ et $K_u = 0$ J/m$^3$ ;
- Figure 7a : Graphiques de $M_S^{FM\,opti}$ and $t^{FM\,opti}$ calculés pour une anisotropie magnétocristalline de $K_u^{FM} = 0$. Ces courbes correspondent à l'empilement FM monocouche, pour une stabilité $\Delta_{300} = 60$ ;
- Figure 7b : Identique à Fig. 7a à l'exception près que l'anisotropie magnétocristalline vaut $K_u^{FM} = 0.3\ 10^6$ J/m$^3$ ;
- Figure 7c : Graphiques de $M_S^{FM\,opti}$ and $t^{FM\,opti}$ calculés pour une anisotropie magnétocristalline de $K_u^{FM} = 0$. Ces courbes correspondent à l'empilement FeCoB/FM avec $M_S^{FeCoB} = 1.0\ 10^6$ A/m , $t_{FeCoB} = 1.4$ nm et $K_S^{FeCoB} = 1.4\ mJ/m^2$ , pour une stabilité $\Delta_{300} = 60$ ;
- Figure 7d : Identique à Fig.7c à l'exception près que l'anisotropie magnétocristalline vaut $K_u^{FM} = 0.3\ 10^6$ J/m$^3$ ;

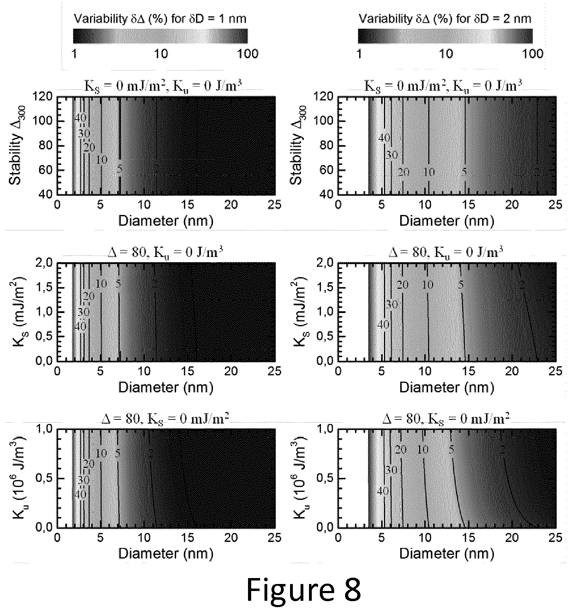

- Figure 8 : Graphiques représentant en code couleur la variabilité du facteur de stabilité thermique (et donc aussi du courant d'écriture) en fonction du diamètre de la cellule pour deux variabilités données du diamètre de la cellule (variabilité associée au procédé de gravure : $\delta D=1nm$ colonne de gauche, $\delta D=2nm$, colonne de droite). Sur ces figures, 3 paramètres ont été variés $\Delta$, $K_s$ et $K_u$. Les échelles verticales représentent chacune un de ces paramètres, les deux autres étant fixés. Pour chaque ensemble de valeurs de paramètres $\Delta$, $K_s$ et $K_u$, D, l'épaisseur L et l'aimantation Ms sont choisies pour correspondre aux paramètres optimaux { $L^{opti}$, $M_S^{opti}$ } ;
- Fig.9 : Procédé de fabrication d'une jonction tunnel selon l'invention ;
- Fig. 10 : Implémentation de la jonction obtenue par le procédé de l'invention dans une cellule mémoire de SOT-MRAM ; a) Configuration « top » ; b) Configuration « bottom » ;
- Fig. 11 : Implémentation de la jonction obtenue par le procédé de l'invention, non revendiquée, dans une MRAM contrôlée par tension (VC-MRAM). La configuration bottom est aussi possible ;
- Fig.12 : Exemple de composant logique non volatile utilisant des jonctions tunnel obtenues par le procédé de l'invention, non revendiquée, ici une latch non volatile ;
- Fig.13 : Evolution en température du facteur de stabilité thermique de p-STT-MRAM selon l'état de l'art à aimantation hors du plan pour des jonctions tunnel de diamètre entre 100nm et 44nm ;
- Fig.14 : Dépendance en température de l'anisotropie interfaciale de premier ordre (uniaxial en $\sin^2 \theta$ , $\theta$ angle entre l'aimantation de la couche de stockage et la normale au plan des couches) et de second ordre (en $\sin^4 \theta$) de multicouches W/CoFeB/MgO avec différentes épaisseurs de CoFeB. Tiré de Kyoung-Min Lee et al., "Température dependence of the interfacial magnetic anisotropy in W/CoFeB/MgO", AIP Advances 7, 065107 (2017).

- Fig.15 : Variation thermique de l'aimantation du cobalt massif.

## DESCRIPTION DETAILLEE DE L'INVENTION

Sauf précision contraire, un même élément apparaissant sur des figures différentes présente une référence unique.

La figure 2 représente schématiquement trois exemples de jonction tunnel magnétique PSA-STT-MRAM obtenue par le procédé de l'invention.

Selon la variante a), la jonction tunnel comprend une couche de référence d'aimantation fixe hors du plan RL, une barrière tunnel TB et une couche de stockage SL présentant un rapport de forme vertical épaisseur/(dimension caractéristique planaire) compris entre 0.5 et 8. La couche de référence RL présente une aimantation perpendiculaire fixe représentée par une flèche simple. La couche de stockage présente une aimantation perpendiculaire commutable entre deux états d'aimantation normales au plan des couches, représentée par une flèche double. Dans la configuration a) dite « top », la couche de stockage SL est au-dessus de la barrière tunnel TB et la couche de référence RL en dessous. Dans la configuration b) dite « bottom », la couche de stockage est en dessous de la barrière tunnel TB et la couche de référence RL au-dessus. Pour des raisons de qualité de croissance et de facilité de fabrication, la configuration a) est préférable dans la mesure du possible.

La configuration de la figure 2c) représente une jonction tunnel dans laquelle les flancs de la jonction sont légèrement inclinés au lieu d'être quasiment verticaux. Cette forme avec flancs inclinés peut provenir de la gravure de la jonction par gravure par faisceau d'ions (IBE). Même si quantitativement l'anisotropie de forme de la couche de stockage SL est modifiée de part cette forme tronconique, une anisotropie de forme verticale peut aussi être obtenue et les autres paramètres peuvent être adaptés à cette forme par l'homme de l'art selon la présente invention.

Par exemple la couche de référence RL peut comprendre un alliage CoFeB avec une épaisseur comprise entre 1 et 3 nm. La couche barrière tunnel TB peut comprendre du MgO avec une épaisseur comprise entre 0.6 et 2 nm.

La figure 3 montre un diagramme du facteur de stabilité thermique $\Delta$ en code couleur en fonction du diamètre de la couche de stockage et de son épaisseur.

Les paramètres choisis pour établir ce diagramme sont représentatifs d'une couche interfaciale de FeCoB (jusqu'à 1.4 nm d'épaisseur) complétée par une couche de cobalt.

La partie supérieure du diagramme correspond à une jonction tunnel obtenue selon le procédé de l'invention PSA-STT-MRAM avec une couche de stockage en Co épaisse.

La partie inférieure du diagramme correspond à une jonction tunnel magnétique p-STT-MRAM selon l'état de l'art, hormis le document "Shape anisotropy revisited in single-digit nanometer magnetic tunnel junctions".

L'interprétation de ce diagramme pour la compréhension de l'invention a été donnée plus haut.

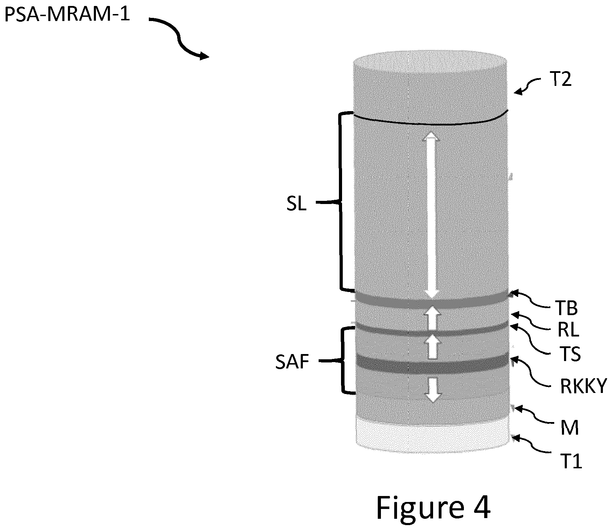

La figure 4 décrit un premier mode de réalisation particulier d'une jonction tunnel magnétique obtenue par le procédé de l'invention ou PSA-MRAM-1 dans laquelle la couche de stockage SL est composée d'une couche ferromagnétique FM unique c'est-à-dire constituée d'un seul matériau homogène.

La jonction tunnel illustrée à la figure 4 comprend de bas en haut :

- Une couche de contact électrique inférieur T1;
- une couche de croissance métallique M ;
- un élément synthétique antiférromagnétique SAF constitué de deux couches ferromagnétiques couplées antiferromagnétiquement à travers une couche de couplage RKKY par exemple de Ru d'épaisseur 0.3nm à 0.8nm d'épaisseur ;
- une couche de transition structurale TS apte à absorber le bore, par exemple en Ta ou W ;
- une couche de référence RL typiquement en CoFeB d'épaisseur 1 à 3nm ;
- une barrière tunnel TB le plus souvent en MgO d'épaisseur entre 0.6 et 2nm ;
- la couche de stockage SL présentant un rapport de forme allongé verticalement, la couche de stockage étant formée d'une couche FM comprenant un matériau homogène donnant une forte magnétorésistance tunnel et de préférence à faible amortissement de Gilbert tel qu'un alliage à base de Co, de Fe et de B.

Cette couche FM est surmontée d'une couche métallique T2 permettant d'absorber l'élément amorphisant (ici le B) et aussi servant de contact électrique supérieur et éventuellement de masque dur pendant la gravure du point mémoire.

La configuration symétrique « bottom » est également possible.

En partant de sa base, la jonction tunnel PSA-MRAM-1 comprend sur un substrat T1 une couche d'accroche et de croissance M destinée à favoriser l'adhérence de la jonction tunnel sur son substrat et à promouvoir une bonne texture de croissance pour la suite de la jonction. Elle comprend ensuite une couche antiferromagnétique SAF synthétique bien connue de l'homme de l'art, constituée de deux couches ferromagnétiques dont les aimantations sont couplées antiparallèlement à travers une fine couche RKKY assurant un couplage antiparallèle entre les aimantations des couches ferromagnétiques. Cette couche de couplage est constituée d'un matériau tel que le ruthénium ou l'iridium d'épaisseur convenablement choisie pour que le couplage soit antiparallèle. Par exemple, pour le ruthénium, les épaisseurs donnant un couplage antiparallèle sont typiquement entre 0.3nm et 0.8nm. Les couches ferromagnétiques sont constituées de multicouches telles que (Co/Pt) ou (Co/Pd) ou d'alliages CoPt ou CoPd ou d'alliages ordonnés L10 de type FePt ou FePd connus pour avoir une anisotropie magnétique hors du plan. Cette multicouche antiferromagnétique synthétique SAF est surmontée d'une fine couche métallique nanocristallisée TS typiquement en Ta, W ou Mo ayant plusieurs buts :

- assurer une transition structurale entre la multicouche synthétique antiferromagnétique généralement de structure cubique face centrée (fcc) de symétrie d'ordre 3 dans la direction de croissance privilégiée (111) et la couche d'alliage CoFeB en contact avec la barrière tunnel qui est de structure cubique centrée donc de symétrie d'ordre 4 ;
- absorber le bore ou l'élément amorphisant si celui-ci est autre que le bore (par exemple Zr, Nb..) hors de la couche de CoFeB en contact avec la barrière tunnel de MgO lors du recuit post-dépôt nécessaire à la bonne cristallisation de la barrière de MgO et de ses électrodes. Cette couche est suffisamment fine (typiquement entre 0.2nm et 0.4nm) pour fournir un fort couplage ferromagnétique entre la multicouche antiferromagnétique synthétique et la couche de CoFeB.

Cette couche de transition structurale TS est elle-même surmontée d'une couche d'alliage CoFeB d'épaisseur typiquement entre 1 et 2nm qui constitue l'électrode de référence RL de la jonction tunnel. L'aimantation de cette couche reste fixe hors du plan pendant l'opération de la mémoire.

Cette couche est surmontée par la barrière tunnel TB de MgO d'épaisseur typique de 0.6 à 2nm. Cette épaisseur permet de contrôler le produit résistance x surface (RA) de la jonction. Dans les STT-MRAM, ce produit RA est généralement choisi entre 1 et 10 $\Omega.\mu m^2$ pour que la jonction tunnel ait une résistance comparable à celle du transistor de sélection en mode passant qui est connecté à la jonction tunnel.

La barrière tunnel TB est surmontée par l'électrode magnétique de stockage SL constituée dans ce premier mode de réalisation d'une couche unique de matériau magnétique réalisée en alliage à base de Co, de Fe, de Ni et d'un élément amorphisant, de préférence le bore mais d'autres éléments amorphisants pourraient être utilisés comme le Zr ou le Nb. L'épaisseur de cette couche sera choisie entre 0.5 et 8 fois le diamètre visé pour la jonction tunnel après nanostructuration.

Cette couche ferromagnétique est surmontée par une ou plusieurs couches métalliques T2. Un premier but de cette couche métallique est d'absorber l'élément amorphisant hors de l'électrode magnétique de stockage lors du recuit post-dépôt nécessaire à la bonne cristallisation de la barrière tunnel et des électrodes magnétiques. Cette couche apte à absorber l'élément amorphisant peut être réalisée en tantale (Ta), tungsten (W), molybdène (Mo) etc.

Eventuellement, plusieurs laminations de cette couche apte à absorber le bore ou l'élément amorphisant peuvent être introduites dans l'épaisseur de la couche ferromagnétique de stockage pour améliorer la recristallisation de l'alliage. Par exemple une couche de CoFeB 16nm surmontée d'une couche de Mo de 4nm pourra être remplacée par une mutlicouche (CoFeB 4nm/Mo 2nm)$_4$/Mo 2nm.

La couche ferromagnétique de stockage SL peut aussi être surmontée d'une deuxième couche d'oxyde (deuxième barrière tunnel) destinée à renforcer l'anisotropie perpendiculaire de la couche de stockage. Dans ce cas, en plus de l'anisotropie de forme de la couche de stockage, celle-ci bénéficie aussi de l'anisotropie d'interface non seulement à l'interface avec la barrière tunnel mais aussi à l'interface avec cette deuxième couche d'oxyde. Il faut veiller alors à ce qu'une ou plusieurs couches aptes à absorber l'élément amorphisant de la couche de stockage soient insérées dans la couche de stockage comme décrit précédemment. Comme il est connu de l'homme de l'art, la deuxième barrière tunnel doit avoir un produit résistance surface suffisamment faible par rapport à la première barrière tunnel qui fournit le signal de magnétorésistance tunnel pour ne pas trop réduire ce signal du fait de la résistance en série associée avec cette deuxième barrière tunnel.

D'autres fonctions de la ou des couches métalliques supérieures T2 sont de permettre un contact électrique au sommet de la structure et éventuellement de servir de masque dur de gravure lors de la gravure de la jonction tunnel.

La structure décrite sur la Figure 4 est présentée en configuration « top ». Il va de soi que la configuration « bottom » peut aussi être réalisée en inversant l'empilement c'est-à-dire avec la couche de stockage sous la barrière tunnel et la couche de référence en la couche de SAF au-dessus de la barrière.

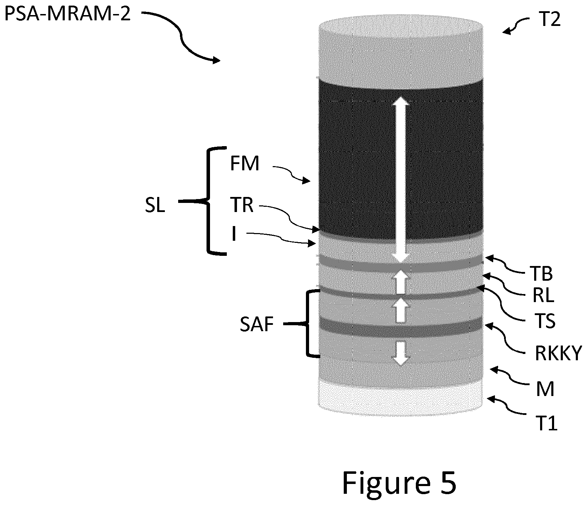

La figure 5 illustre une jonction tunnel magnétique PSA-MRAM-2 selon un deuxième mode de réalisation obtenu par le procédé de l'invention.

La jonction magnétique tunnel PSA-MRAM-2 comprend de bas en haut :

- une couche de contact électrique inférieur T1;
- une couche de croissance métallique M ;
- un synthétique antiferromagnétique SAF constitué de deux couches ferromagnétiques couplées antiferromagnétiquement à travers une couche de couplage RKKY par exemple de Ru d'épaisseur 0.3nm à 0.8nm d'épaisseur,

- une couche de transition structurale TS apte à absorber le bore par exemple en Ta ou W,
- une couche de référence RL typiquement en CoFeB,
- une barrière tunnel TB le plus souvent en MgO,
- une couche de stockage SL présentant un rapport de forme allongé verticalement, la couche de stockage étant formée d'une partie interfaciale I par exemple en FeCoB, d'une fine couche de transition TR, par exemple en Ta ou W ou Mo et d'une couche épaisse ferromagnétique FM.
- une couche métallique T2 servant de contact électrique supérieur et éventuellement de masque dur pendant la gravure du point mémoire. La configuration symétrique « bottom » est également possible.

Ainsi dans ce deuxième mode de réalisation PSA-MRAM-2, la couche de stockage SL, au lieu d'être constituée d'un matériau homogène, est constituée d'un ensemble de couches magnétiques et non magnétiques comme illustré par exemple sur la figure 5. En particulier, si la barrière tunnel est en MgO comme c'est le cas le plus souvent, il est avantageux de conserver près de l'interface avec la barrière tunnel TB une couche interfaciale I d'alliages CoFeB de 1.5 à 3nm d'épaisseur permettant d'obtenir une forte magnétorésistance tunnel. Par forte magnétorésistance tunnel, on entend une magnétorésistance d'au moins 100%. On rappelle que la magnétorésistance (TMR) correspond à la variation relative de résistance de la structure entre la valeur minimale $R_{min}$ obtenue dans la configuration magnétique parallèle des aimantations des électrodes de la jonction tunnel magnétique et la valeur maximale $R_{max}$ obtenue lorsque les aimantations sont antiparallèles. La TMR est définie par $TMR=(R_{max}-R_{min})/ R_{min}$. Cette fine couche magnétique I peut être associée à une couche épaisse de NiFe ou d'alliages à base de Co, Fe, Ni et éventuellement d'autres additifs (V, Al, Mo...) présentant en particulier un faible amortissement de Gilbert. Par faible amortissement de Gilbert, on entend un amortissement inférieur à 0.02. Cette couche est notée FM. Avantageusement, les deux couches magnétiques sont séparées par une couche non magnétique TR par exemple de Mo, W ou Ta de 0.2 à 0.4nm d'épaisseur permettant d'absorber le bore de la couche de CoFeB lors du recuit post-dépôt nécessaire à la bonne cristallisation de la barrière de MgO et des électrodes de CoFeB comme cela est connu dans les STT-MRAM de l'état de l'art.

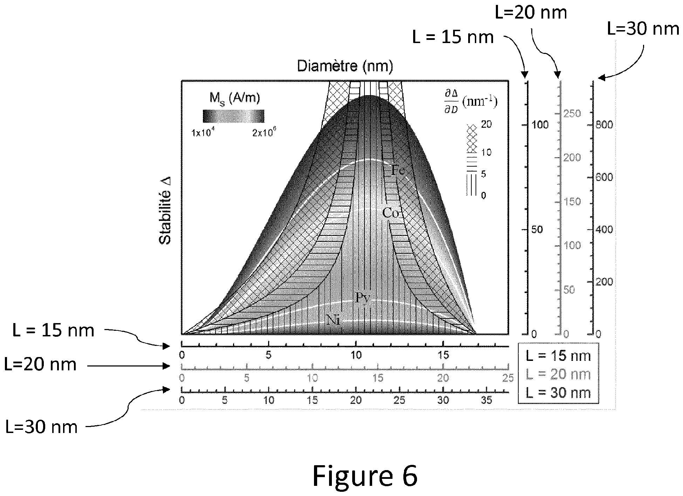

La figure 6 montre $\Delta$ en fonction de D dans l'approximation macrospin, pour un cylindre avec $K_S = 0$ J/m² et $K_u = 0$ J/m³. Ces courbes montrent clairement qu'un maximum de $\Delta(D)$ est toujours atteignable, quel que soit la valeur de l'épaisseur et du Ms de la couche. Se placer autour de ce maximum est avantageux car cela montre que le facteur de stabilité thermique $\Delta$ est alors faiblement dépendant du diamètre exact du pilier constitué par la jonction tunnel magnétique. On peut facilement se convaincre en traçant ces mêmes courbes pour différentes valeurs de Ks et $K_u$ que, dans le régime de fonctionnement des PSA-MRAM, la fonction $\Delta(D)$ présente toujours un unique maximum. Ainsi, même en présence d'anisotropie interfaciale et volumique donnée : Ks et $K_u$, il existe une unique solution optimale { $L^{opti}$, $Ms^{opti}$ } qui minimise les effets d'une variabilité de diamètre sur la stabilité, pour une stabilité et un noeud technologique (i.e. un diamètre) prédéfini.

Les calculs ci-dessous présentent une résolution analytique des paramètres { $L^{opti}$, $Ms^{opti}$ } dans la limite de l'approximation de l'expression approchée des facteurs démagnétisants d'un cylindre uniformément aimanté évoquée plus haut. Les applications numériques seront faites pour certaines valeurs d'anisotropies Ks et $K_u$ typiquement réalisables avec les matériaux connus de l'homme de l'art. L'invention ne se limite nullement au cas du cylindre uniformément aimanté ou à des valeurs d'anisotropies choisies en exemple. Afin d'alléger les expressions, des constantes « a », « b » et « c » sont introduites dans l'expression du facteur de stabilité thermique.

$$\Delta \ = \ aLD^2 \left(1 - \frac{3D}{D + bL}\right) + cD^2(K_u L + K_S)$$

où

$$a = \frac{\pi\mu_0 M_S^2}{16\, k_B T} \quad b = \frac{4}{\sqrt{\pi}} \quad c = \frac{\pi}{4\, k_B T}$$

La condition d'optimisation s'écrit :

$$\frac{\partial \Delta}{\partial D} = \frac{2\Delta}{D} - \frac{3abL^2D^2}{(D+bL)^2} = 0$$

$$\Rightarrow a = \frac{2\Delta(D+bL)^2}{3bL^2D^3}$$

Cette expression de « a » est injectée dans l'expression du facteur de stabilité thermique. Après simplifications, il est possible d'extraire une équation quadratique en L.

$$L^2\left[\frac{1}{2} + \frac{3cD^3K_u}{4b\Delta}\right] + L\left[-\frac{5D}{4b} + \frac{3cD^3K_S}{4b\Delta}\right] - \frac{D^2}{b^2} = 0$$

Parmi les deux racines $L_{\pm}$,, seule $L_+$ est positive et correspond donc à l'épaisseur optimale précédemment nommée $L^{opti}$.

$$L^{opti} = \frac{1}{1 + \frac{3cD^3K_u}{2b\Delta}}\left[\frac{5D}{4b} - \frac{3cD^3K_S}{4b\Delta} + \sqrt{\left(\frac{5D}{4b} - \frac{3cD^3K_S}{4b\Delta}\right)^2 + \frac{2D^2}{b^2}\left(1 + \frac{3cD^3K_u}{2b\Delta}\right)}\right]$$

On en déduit $M_S^{opti}$ :

$$M_S^{opti} = \sqrt{\frac{16\,k_B T}{\pi\mu_0}\frac{2\Delta(D + b\,L^{opti})^2}{3b(L^{opti})^2D^3}}$$

A titre d'exemples, on cite quelques exemples de matériaux magnétiques standards ayant une aimantation $M_S^{FM\,opti}$ qui minimisent la variabilité de $\Delta_{300}$ pour des valeurs de diamètre de jonctions entre 10nm et 25nm :

- FM = Cobalt. Une couche de 15 nm de Co ($M_S$ = 1.446 $10^6$ A/m, $K_u$ = 0 J/m$^3$) correspond à la couche optimale pour un diamètre de jonction de D = 10.8 nm.
- FM = Fer. Une couche de 13.4 nm de Fe ($M_S$ = 1.714 $10^6$ A/m, $K_u$ = 0 J/m$^3$) correspond à la couche optimale pour un diamètre de jonction de D = 9.6 nm.
- FM = Permalloy (Py). Une couche de 23.1 nm de Py (Ms = 0.756 $10^6$ A/m, $K_u$ = 0 J/m$^3$) correspond à la couche optimale pour un diamètre de jonction de D = 16.6 nm.
- FM = Alliages CoFe. Ces alliages sont optimaux pour des diamètres de jonctions compris entre 10 et 15 nm.
- FM = Co$_2$FeAl (full-Heusler). Une couche d'environ 6 nm de Co$_2$FeAl (Ms = 1.3 $10^6$ A/m, $K_u$ = 0.3 $10^6$ J/m$^3$) correspond à la couche optimale pour des diamètres de jonctions d'environ 25 nm.

Finalement, dans le cas d'une bicouche comportant une couche d'interface à base de FeCoB dont on suppose les propriétés optimisées pour d'autres raisons (TMR, RA, polarisation en spin, etc) ainsi qu'une couche de volume notée FM, les caractéristiques optimales (épaisseur optimale $L^{FM\,opti}$ et aimantation optimale $M_s^{FM\,opti}$ ) de la couche FM sont données par :

$$\begin{cases} L^{FM\,opti} &= & L^{opti} - L^{FeCoB} \\ M_S^{FM\,opti} &= & \dfrac{M_S^{opti}\,L^{opti} - M_S^{FeCoB}\,L^{FeCoB}}{L^{opti}} \end{cases}$$

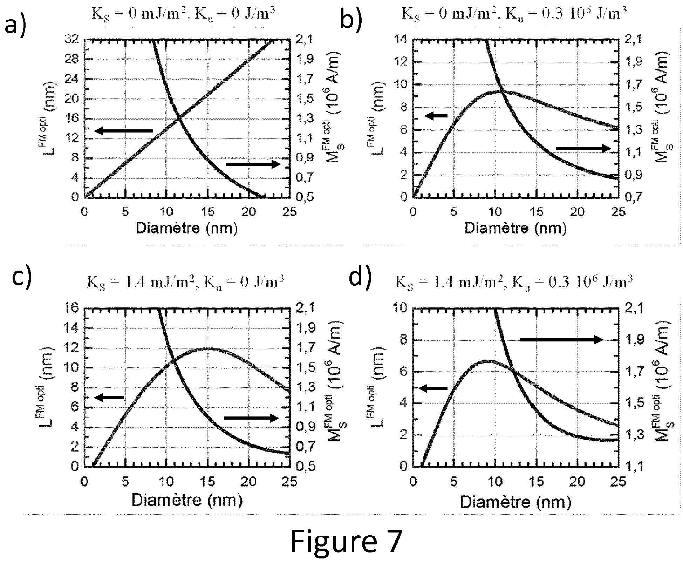

Ce point correspond aux maxima des iso-Ms de la figure 6 ou encore aux minima iso-Δ de la figure 3. La figure 7 représente $L^{FM\,opti}$ et $M_S^{FM\,opti}$ en fonction du noeud technologique (identifié ici au diamètre du point mémoire) pour une stabilité Δ = 60 à 300 K, pour un empilement possédant ou non une anisotropie de surface. Deux valeurs d'anisotropie de volume y sont présentées.

Les graphes illustrés aux figures 7a à 7d représentent les graphiques de $M_S^{FM\,opti}$ and $L^{FM\,opti}$ calculés pour différentes valeurs d'anisotropie $K_s$ et $K_u$ en fonction du diamètre de la jonction tunnel.

Afin de minimiser la dispersion de facteur de stabilité thermique et de courant d'écriture d'un point mémoire à l'autre, on se placera dans des conditions telles que

$$\left|\frac{\partial \Delta}{\partial D}\right| < \text{crit}$$

Où *crit* est une constant positive de tolérance de dispersion. égale à 10 nm$^{-1}$. Cette tolérance est définie par le fait que les distributions de tension d'écriture, de tension de lecture et de tension de claquage diélectrique doivent être bien séparées comme il est connu de l'homme de l'art. Typiquement, on cherchera à avoir une dispersion de Δ inférieure à 40 (c'est-à-dire par exemple Δ=80±20 pour une dispersion de diamètre de jonctions tunnel de ±2nm) soit $\left|\frac{\partial \Delta}{\partial D}\right| < 10\text{nm}^{-1}$. Toutefois pour réaliser des mémoires de haute capacité (quelques Gbit), il sera nécessaire d'avoir une distribution de tension d'écriture plus étroite donc un critère plus stricte $\left|\frac{\partial \Delta}{\partial D}\right| < 3\text{nm}^{-1}$ voire $\left|\frac{\partial \Delta}{\partial D}\right| < 1\text{nm}^{-1}$. Ceci signifie travailler de plus en plus proche de la condition optimale définie par $L^{FM\,opti}$ et $Ms^{FM\,opti}$.

Dans le cas d'une couche de stockage constituée d'un seul matériau homogène d'aimantation uniforme, la condition $\left|\frac{\partial \Delta}{\partial D}\right| < \text{crit}$ s'écrit $\left|\frac{2\Delta}{D} - \frac{3abL^2D^2}{(D+bL)^2}\right| < \text{crit}$ où les constantes a et b ont été précédemment définies.

La figure 6 illustre les zones de paramètres (diamètre (D), épaisseur (L)) dans lesquelles on obtient une valeur $\left|\frac{\partial \Delta}{\partial D}\right|$ inférieure à un certain critère crit égal à 5, 10, ou 20nm$^{-1}$ sur la figure. La figure est représentée sous une forme multiéchelle permettant de couvrir différents types de matériaux représentés par leur aimantation en code couleur. Pour établir cette figure, on calcule les variations de stabilité δΔ qu'implique une variation de diamètre δD donnée (c'est-à-dire $\left|\frac{\partial \Delta}{\partial D}\right|$ ), en fonction des paramètres D, Δ, L et Ms et en considérant $K_S$ = 0 et $K_u$ = 0. On trace alors en code de hachure la valeur de $\left|\frac{\partial \Delta}{\partial D}\right|$ en fonction de Δ (axe des ordonnées) et de D (axe des abscisses), pour tout Ms (code couleur) et pour différentes valeurs de L (axes colorés). Des hachures verticales indiquent que $\left|\frac{\partial \Delta}{\partial D}\right| < 5$ nm$^{-1}$, des hachures horizontales indiquent que $5 < \left|\frac{\partial \Delta}{\partial D}\right| < 10$ nm$^{-1}$, des hachures en croix indiquent que $10 < \left|\frac{\partial \Delta}{\partial D}\right| < 20$ nm$^{-1}$ et tout ce qui est au-delà des hachures indique que $\left|\frac{\partial \Delta}{\partial D}\right| > 20$ nm$^{-1}$. Il est raisonnable de considérer que Δ ne doit pas varier de plus de ±20 pour des variations de diamètre de ±2 nm, soit $\left|\frac{\partial \Delta}{\partial D}\right| < 10$ nm$^{-1}$. Ainsi, les zones hachurées verticales et horizontales montrent tout le domaine dans lequel on peut se placer tout en satisfaisant cette propriété. Par exemple, considérons le cas du Cobalt (courbe iso-Ms = Co) avec une épaisseur L = 15 nm (axes bleus). Les conditions optimales ( $\left|\frac{\partial \Delta}{\partial D}\right| = 0$ ) de ce cas correspondent au maximum de l'iso-Ms et correspondent environ au point de fonctionnement {D = 10.9 nm, Δ = 60}. En revanche, comme le critère est

$\left|\frac{\partial \Delta}{\partial D}\right| < 10$ nm$^{-1}$ au lieu d'être $\left|\frac{\partial \Delta}{\partial D}\right| = 0$, mais l'on veut spécifiquement avoir $\Delta = 55$, il est possible en se déplaçant vers la gauche sur l'iso-Ms de trouver un point de fonctionnement { D = 8.8 nm, $\Delta = 55$} qui satisfasse toujours le critère désiré. Le critère n'est plus satisfait pour environ D < 8.1 nm, ce qui laisse la possibilité d'avoir une variabilité de procédé de $\pm$ 0.7 nm.

La Figure 8 montre une autre façon de présenter l'influence de la variabilité du facteur de stabilité thermique pour une variabilité de diamètre de cellule donnée $\delta D$ (1nm ou 2nm sur la Figure 8) en fonction du diamètre de la cellule dans différentes conditions d'anisotropie de surface et de volume. Pour chaque valeur de diamètre, et de paramètres d'anisotropie $K_s$ et $K_u$ fixés, on se place aux conditions optimales d'épaisseur et d'aimantation { $L^{opti}$, $M_S^{opti}$ }.

Pour ce faire, les résultats présentés en figure 8, sont calculés de la manière suivante. L'axe des abscisses représente le diamètre cible D. L'axe des ordonnées représente un paramètre variable $\Delta$, Ks ou $K_u$, les deux autres étant fixés. Pour chaque point des diagrammes, les paramètres optimaux { $L^{opti}$, $M_S^{opti}$ } sont calculés via la méthode présentée précédemment. En utilisant l'ensemble de ces paramètres, on trace en code couleur la variation relative de stabilité maximale $\delta \Delta$ (en % de la stabilité cible $\Delta$) lors d'une variabilité du diamètre D $\pm$ $\delta D$. En d'autres termes, pour toutes valeurs de diamètre $\in$ [D - $\delta D$; D + $\delta D$], on a une stabilité e [$\Delta(1 - \delta \Delta)$; $\Delta(1 + \delta \Delta)$]. Les diagrammes sont calculés pour $\delta D$ = 1 nm (colonne gauche) et $\delta D$ = 2 nm (colonne droite). Ces diagrammes permettent de conclure que pour les plus grands diamètres (D > 15 nm), il peut être avantageux d'avoir une anisotropie de surface ou volumique puisque ces dernières diminuent la variabilité $\delta \Delta$. Elles n'ont en revanche que peu d'influence aux petits diamètres (D < 15 nm). De plus, pour les plus grands diamètres, la variabilité $\delta \Delta$ est généralement inférieure à 2%, ce qui est faible et ce qui permet que se placer relativement loin des conditions optimales présentées dans le présent brevet. En revanche, plus le diamètre est petit, plus la variabilité $\delta \Delta$ aux conditions optimales augmente. A titre d'exemple, $\delta \Delta$ atteint les 40% pour $\delta D$ = 1 nm à D = 2.7 nm, et $\delta \Delta$ atteint les 40% pour $\delta D$ = 2 nm à D = 5.3 nm. Ainsi, si $\delta D$ = 2 nm est l'incertitude sur le procédé et $\delta \Delta$ = 40% la variation de stabilité maximale autorisée, alors si le diamètre cible est de 5 nm, alors il faut nécessairement se placer très proches des conditions optimales { $L^{opti}$, $M_S^{opti}$ } puisqu'ailleurs la variabilité $\delta \Delta$ ne peut que s'aggraver.

Il est à noter que dans certaines situations et en particulier vers les noeuds technologiques les plus petits (4nm), il peut devenir impossible de trouver un matériau possédant une aimantation optimale $M_S^{FM \ opti}$, que ce soit pour des raisons purement physiques (par exemple aucun matériau n'ayant l'aimantation optimale si celle-ci est trop grande) ou parce que lesdits matériaux ne satisfont pas d'autres critères (par exemple nécessité d'avoir un faible amortissement de Gilbert). Ceci peut se produire en particulier vers les plus petits noeuds technologiques dans la mesure où d'une façon générale, l'aimantation optimale du matériau de la couche ferromagnétique de stockage augmente lorsque le diamètre de la jonction tunnel diminue. Dans ce cas, s'il devient impossible de satisfaire l'égalité $\frac{\partial \Delta}{\partial D} = 0$, on va chercher à se placer au point de plus bas ( $\left|\frac{\partial \Delta}{\partial D}\right|$ ) accessible. Une analyse des diagrammes tel que celui donné en figure 7 conduit au fait qu'il faut choisir le matériau possédant la plus grande aimantation Ms (avec $M_S < M_S^{opti}$ ), puis adapter l'épaisseur pour obtenir la stabilité souhaitée. Dans ce cas, l'épaisseur s'obtient suivant :

$$L = \frac{1}{2(abD^2 + bcD^2 K_u)} \Big[ (2aD^3 + b\Delta - cD^3 K_u - bcD^2 K_S) + \sqrt{(2aD^3 + b\Delta - cD^3 K_u - bcD^2 K_S)^2 + 4(abD^2 + bcD^2 K_u)(D\Delta - cD^3 K_S)} \Big]$$

Il est à noter que les valeurs de L$^{FM \ opti}$ et Ms$^{FM \ opti}$ dépendent de la température. Avantageusement, pour un dispositif devant fonctionner sur une gamme de température de $T_{min}$ à $T_{max}$, par exemple 0°C à 85°C, on cherchera à se rapprocher des conditions optimales à la température moyenne d'utilisation $T_m = (T_{min} + T_{max})/2$. Notons qu'il est aussi possible de donner à la couche de référence une forme verticalement allongée pour augmenter son anisotropie perpendiculaire. Toutefois un inconvénient est qu'alors le champ rayonné par cette couche sur la couche de stockage devient très important de sorte qu'il peut devenir nécessaire de compenser ce champ rayonné par l'application d'un champ magnétique de compensation.

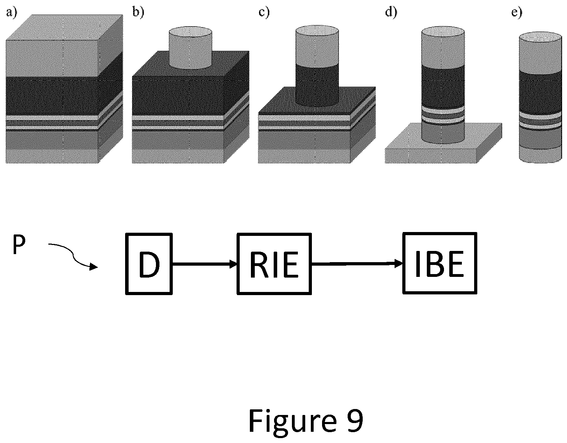

La figure 9 décrit un procédé P de fabrication de la jonction tunnel PSA-MRAM-1 ou PSA-MRAM-2 selon l'invention.

En particulier, la figure 9 illustre : (a) le dépôt de l'ensemble des couches constitutives de l'empilement, (b) la gravure ionique réactive de l'électrode supérieure, (c) la gravure ionique de la couche épaisse FM appartenant à la couche de stockage, (d) une gravure ionique du reste de la jonction tunnel et (e) gravure ionique réactive de l'électrode inférieure ;

Le procédé P selon l'invention comprend les étapes suivantes :

- Dépôt D de l'ensemble des couches par dépôt par phase vapeur ;
- Gravure RIE de la couche de stockage ou couche magnétique épaisse par gravure ionique réactive ;
- Gravure IBE des autres couches par gravure ionique.

Après dépôt de l'ensemble des couches par un procédé de dépôt par phase vapeur comme la pulvérisation cathodique, on définit par lithographie et gravure un masque dur à la surface de l'empilement. La couche constituant le masque dur peut par exemple être en tantale que l'on grave facilement par gravure ionique réactive.

Ensuite avantageusement, on cherchera à graver la couche magnétique épaisse par gravure ionique réactive. Plusieurs articles décrivent des moyens pour graver le Permalloy ou le cobalt par gravure ionique réactive en utilisant des gaz réactifs à base de methanol ou de monoxyde de carbone éventuellement combinés avec de l'argon (Developement of methanol based reactive ion etching process for nanoscale magnetic devices, M.T.Moneck and J.G.Zhu, NSTI-Nanotech 2011). Comme cette couche magnétique est épaisse, il est particulièrement avantageux d'essayer de la graver par gravure ionique réactive pour éviter beaucoup de dépôt de ce matériau magnétique gravé. Si la couche magnétique épaisse est constituée de plusieurs éléments magnétiques, on peut alors graver par gravure ionique réactive au moins le plus épais des deux.

Ensuite le reste de la structure peut être gravée par gravure par faisceau d'ions (IBE) dans la mesure où les couches en jeu sont beaucoup plus fines. Cette méthode est compatible avec des fortes densités de point mémoire (noeud technologique < 10 nm) puisque la gravure de la jonction est presque entièrement réalisée par gravure ionique réactive et que la couche de stockage peut elle-même constituée un masque dur épais pour la gravure de la partie basse de l'empilement.

Dans un deuxième mode de réalisation décrit sur la Figure 5, la couche de stockage ferromagnétique épaisse comprend au moins deux matériaux magnétiques différents. Un premier matériau magnétique en contact avec la barrière tunnel permet d'obtenir une forte magnétorésistance tunnel. Comme dans les p-STT-MRAMs conventionnelles, cette couche interfaciale sera préférentiellement en alliage à base de Co, de Fe et de B ou autre élément amorphisant. Un deuxième matériau magnétique est alors déposé dans la partie de la couche de stockage plus éloignée de la barrière tunnel. Ce deuxième matériau est choisi pour avoir un faible amortissement de Gilbert $\alpha$. En effet, le courant nécessaire à l'écriture par STT étant proportionnel à l'amortissement de Gilbert moyenné surtout le volume de la couche, il est préférable de minimiser cet amortissement moyen. Des matériaux à faible amortissement de Gilbert sont le Permalloy ($Ni_{80}Fe_{20}$), des alliages CoFe de concentration proche de $Co_{25}Fe_{75}$, des alliages d'Heusler. Ces deux matériaux magnétiques pouvant avoir des structures cristallographiques différentes, une couche de transition structurale apte à absorber l'élément amorphisant lors de recuit post-dépôt pourra être introduit entre les deux couches des deux matériaux magnétiques comme représenté sur la Figure 5.

Les autres couches constitutives de l'empilement sont similaires à celles discutées pour le premier mode de réalisation de la Figure 4.

Dans un troisième mode de réalisation, une jonction tunnel magnétique PSA-SOT obtenue par le procédé de l'invention est intégrée dans une cellule de SOT-MRAM.

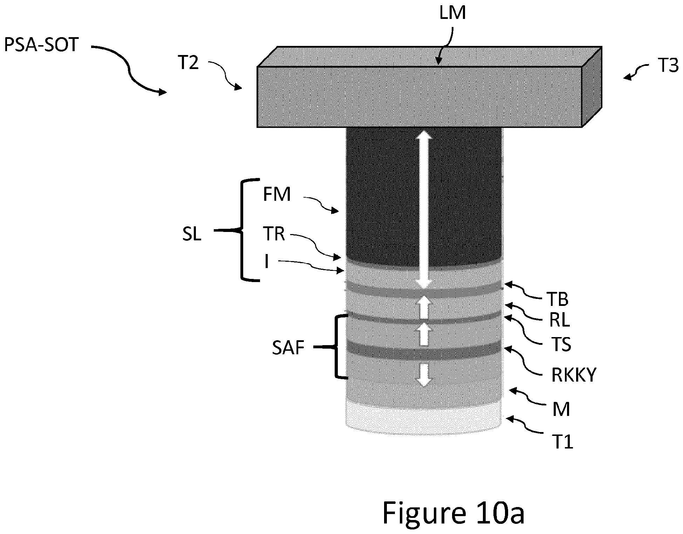

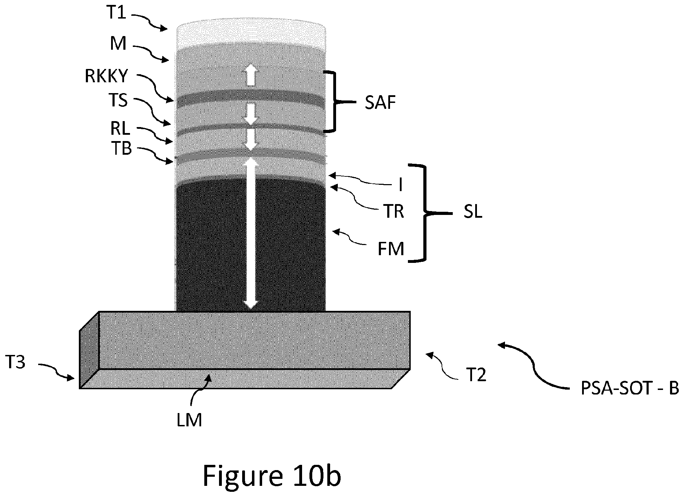

Le dispositif peut être réalisé en configuration « top », illustré à la figure 10a ou « bottom » illustré à la Figure 10b.

La jonction magnétique PSA-SOT illustrée à la figure 10a comprend de bas en haut :

- Une couche de contact électrique inférieur ou terminal $T_1$ ;
- une couche de croissance métallique M ;
- un synthétique antiferromagnétique SAF constitué de deux couches ferromagnétiques couplées antiferromagnétiquement à travers une couche de couplage RKKY par exemple de Ru d'épaisseur 0.3nm à 0.8nm d'épaisseur,
- une couche de transition structurale TS apte à absorber le bore par exemple en Ta ou W,
- une couche de référence RL typiquement en CoFeB,
- une barrière tunnel TB le plus souvent en MgO,
- une couche de stockage SL présentant un rapport de forme allongé verticalement, la couche de stockage étant formée d'une partie interfaciale I par exemple en FeCoB, d'une fine couche de transition TR, par exemple en Ta ou W ou Mo et d'une couche épaisse ferromagnétique FM ;
- une ligne métallique LM parallèle au plan des couches et au contact de la couche de stockage SL et comportant un deuxième contact électrique ou terminal T2 et un troisième contact électrique ou terminal T3.

Comme il est connu de l'homme de l'art, les cellules de SOT-MRAM ont 3 terminaux, T1, T2 et T3. Lors de l'écriture, l'aimantation de la couche de stockage SL est commutée en faisant circuler un pulse de courant dans une ligne conductrice LM parallèle au plan des couches. Le matériau de la ligne conductrice LM est choisi pour avoir un fort angle de Hall de spin. Cette ligne peut être par exemple en métal non-magnétique tel que Pt, Ta, W, Ir ou en métal antiferromagnétique comme IrMn ou PtMn ou autre matériau lourd à fort spin orbite. Un effet spin orbite appelé effet Hall de spin se produisant dans cette ligne conductrice LM permet d'injecter un courant polarisé en spin dans la couche de stockage SL. Ce courant de spin permet de faire commuter l'aimantation de la couche de stockage SL. Comme il est connu de l'homme de l'art, lorsque l'aimantation de la couche de stockage SL est hors du plan, il est nécessaire d'appliquer un champ longitudinal statique (sensiblement parallèle à la ligne conductrice) pour rendre la commutation déterministe. Ce champ peut être créé en insérant à la base ou au sommet de l'empilement une couche de matériau dur rayonnant un champ statique sur la couche de stockage ou en utilisant le champ d'anisotropie d'échange produit à l'interface entre la couche de stockage et la ligne conductrice de métal lourd lorsque celle-ci est antiferromagnétique comme décrit dans l'article : S.Fukami, C.Zhang, S.Dutta Gupta, A.Kurenkov and H.Ohno, Magnetization switching by spin-orbit torque in an antiferromagnet-ferromagnet bilayer system, Nat.Mat.15, 535 (2017).

La figure 10b illustre une jonction tunnel PSA-SOT de type « bottom ».

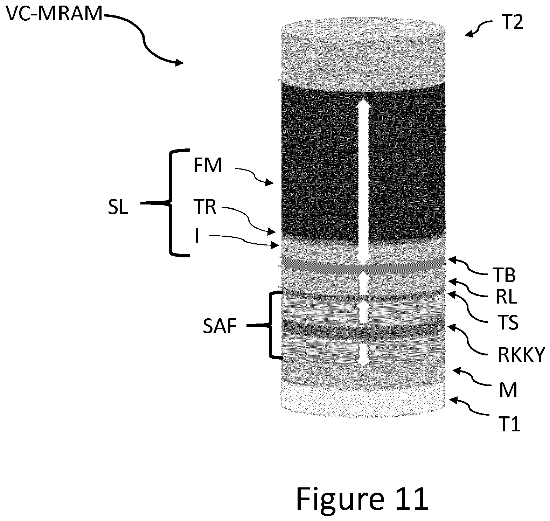

Dans un quatrième mode de réalisation, la jonction tunnel magnétique est utilisée dans une cellule MRAM à écriture contrôlée en tension. Une telle jonction tunnel à écriture contrôlée par tension électrique VC-MRAM est illustrée sur la figure 11.

La jonction tunnel à écriture contrôlée par tension électrique obtenue selon le procédé de l'invention comprend de bas en haut :

- Une couche de contact électrique inférieur T1;
- une couche de croissance métallique M ;
- un synthétique antiferromagnétique SAF constitué de deux couches ferromagnétiques couplées antiferromagnétiquement à travers une couche de couplage RKKY par exemple de Ru d'épaisseur 0.3nm à 0.8nm d'épaisseur,
- une couche de transition structurale TS apte à absorber le bore par exemple en Ta ou W,
- une couche de référence RL typiquement en CoFeB,
- une barrière tunnel TB le plus souvent en MgO,
- une couche de stockage SL présentant un rapport de forme allongé verticalement, la couche de stockage étant formée d'une partie interfaciale I par exemple en FeCoB, d'une fine couche de transition TR, par exemple en Ta ou W ou Mo et d'une couche épaisse ferromagnétique FM.
- une couche métallique T2 servant de contact électrique supérieur et éventuellement de masque dur pendant la gravure du point mémoire. La configuration symétrique « bottom » est également possible.

Comme il est connu de l'homme de l'art, les propriétés magnétiques de certains matériaux magnétiques peuvent être contrôlées par champ électrique. En particulier, l'anisotropie interfaciale à l'interface oxyde/métal magnétique peut être modulée par l'application d'un champ électrique à travers l'oxyde comme décrit par exemple dans : Induction of cohérent magnetization switching in a few atomic layers of FeCo using voltage pulses, Y.Shiota, T.Nozaki, F.Bonell, S.Murakami, T.Shinjo, and Y. Suzuki, Nat.Mat.11, 39 (2012). Egalement, les propriétés volumiques de matériaux magnétiques multiferroïques peuvent être modulées par champ électrique. Ainsi la couche de stockage peut être conçue soit en jouant sur la modulation de l'anisotropie d'interface, soit en jouant sur la modulation d'une aimantation de volume, soit les deux, de sorte que l'application d'une tension aux bornes de la jonction tunnel modifie l'anisotropie de hors du plan à dans le plan initiant une rotation de l'aimantation de hors du plan vers dans le plan. Compte tenu du mouvement precessionel induit par cette rotation initiale, en contrôlant la durée du pulse de tension pour qu'elle soit de l'ordre de la moitié de la période de précession, on peut faire commuter l'aimantation de la direction « vers le haut » à la direction « vers le bas » ou vice versa. La lecture est réalisée sous tension plus faible permettant de mesurer l'état magnétique de la jonction par la magnétorésistance tunnel, la tension étant suffisamment faible pour ne pas perturber l'état magnétique de la jonction. D'une façon générale, ces jonctions ont une épaisseur de barrière légèrement plus grande que dans les jonctions à écriture par transfert de spin pour minimiser le courant circulant à travers la barrière lors de l'écriture.

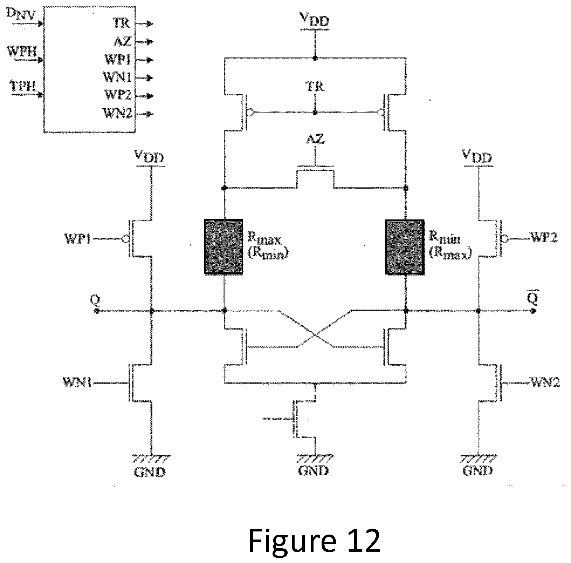

Dans un cinquième mode de réalisation, la jonction obtenue selon le procédé de l'invention est insérée comme élément non volatile dans un composant logique de différentes natures possibles. Différents composants et circuits logiques non volatiles ont été proposés au cours des dernières années à base de jonctions tunnels conventionnelles utilisant des couches de stockage très fines (1 à 3nm d'épaisseur). Ces mêmes composants et circuits peuvent être réalisés en substituant ces jonctions tunnel de l'état de l'art par les jonctions tunnel obtenues selon le procédé de l'invention. A titre d'exemple, la figure 12 montre une latch non volatile comprenant deux jonctions tunnel magnétiques selon l'invention, représentées en gris. Ce circuit est adapté de la demande de brevet US2015/0036415 A1.

## STABILITE THERMIQUE

Selon un autre mode de réalisation, la jonction tunnel magnétique comporte une couche de stockage présentant une épaisseur comprise entre 0.8 et 8 fois une dimension caractéristique d'une section planaire de la jonction tunnel, la contribution à la barrière d'énergie due à l'anisotropie de forme de la couche de stockage étant au moins deux fois supérieure et de préférence au moins quatre fois supérieure aux contributions à la barrière d'énergie d'origine interfaciale.

On entend par barrière d'énergie séparant les deux états d'aimantation de la couche de stockage la différence d'énergie entre le minimum d'énergie correspondant à l'état initial stable de l'aimantation de la couche de stockage et le maximum d'énergie rencontré au cours du retournement de l'aimantation vers son état final stable. On entend par section planaire de la jonction tunnel une section de la jonction tunnel selon le plan des couches formant la jonction tunnel.

On entend par dimension caractéristique d'une section planaire une dimension de ladite section planaire. La jonction tunnel ayant une section circulaire, la dimension caractéristique d'une section planaire de la jonction tunnel peut être choisie comme étant deux fois le rayon du cercle. En cas de section elliptique non revendiquée, la dimension caractéristique peut être choisie comme étant le petit axe ou le grand axe de l'ellipse.

Par exemple, la contribution à la barrière d'énergie due à l'anisotropie de forme de la couche de stockage peut être donnée par la formule suivante :

$$-\frac{\mu_0}{4}\left(1-\frac{3}{1+4AR/\sqrt{\pi}}\right)M_s^2(T)AL$$

Par exemple, la contribution à la barrière d'énergie d'origine interfaciale peut être donnée par la formule suivante :

$$A\left(K_{s1}+K_{s2}\right)$$

L'explication des symboles utilisés dans ces formules a été donnée plus haut.

On peut considérer que ces contributions à la barrière d'énergie sont calculées à une température $T_m$ étant la température moyenne d'utilisation de la jonction magnétique.

Dans l'état de l'art, hormis le document "Shape anisotropy revisited in single-digit nanometer magnetic tunnel junctions", les p-STT-MRAMs ont toujours utilisé des couches de stockage très minces dont l'épaisseur est bien inférieure au diamètre. Ceci était motivé en particulier par le fait que le transfert de spin étant un phénomène interfacial (se produisant typiquement sur le premier nanomètre à partir de l'interface par où le courant polarisé en spin est injecté), il est préférable d'utiliser des couches très minces pour ne pas diluer l'efficacité du couple de transfert de spin. Pour de telles couches très minces, l'anisotropie de forme favorise une orientation dans le plan de l'aimantation de la couche de stockage et s'oppose donc à l'anisotropie interfaciale qui, elle, favorise une orientation perpendiculaire de cette aimantation. Ceci conduit à une anisotropie effective d'amplitude relativement moyenne résultant de la compétition de ces deux termes d'anisotropie. Par ailleurs, cette anisotropie dépend fortement de la température car les fluctuations thermiques d'aimantation se développent plus rapidement quand la température augmente dans une couche très mince (épaisseur de la couche de stockage dans les p-STT-MRAMs de l'état de l'art ~1.4nm à 2nm) que dans une couche épaisse du même matériau.

Le procédé de la présente invention propose de réduire cette dépendance en température de l'anisotropie en changeant complètement de paradigme en utilisant une couche de stockage beaucoup plus épaisse c'est-à-dire dont l'épaisseur est d'au moins 80% d'une dimension planaire caractéristique de la couche de stockage (longueur du petit axe pour un point mémoire de forme elliptique ou diamètre pour un point mémoire de forme cylindrique) de sorte que l'anisotropie de forme favorise aussi une orientation hors du plan de l'aimantation et devient même la principale source d'anisotropie perpendiculaire de la couche de stockage. L'idée de base est que l'anisotropie interfaciale aux interfaces CoFeB/MgO utilisée dans les STT-MRAMs de l'état de l'art dépend beaucoup plus fortement de la température que l'anisotropie de forme d'une couche épaisse qui varie proportionnellement à $M_s^2$, sachant que pour une couche épaisse la variation thermique de $M_s(T)$ est proche de celle du matériau massif de même composition. Dans une jonction tunnel magnétique PSA-STT-MRAM obtenue selon le procédé de l'invention, l'anisotropie de forme et l'anisotropie d'interface ont le même signe et donc s'ajoutent de sorte que toutes les deux favorisent une orientation perpendiculaire au plan des couches de l'aimantation de la couche de stockage. Toutefois, comme l'anisotropie d'interface varie plus rapidement en température que l'anisotropie de forme, on cherchera à augmenter le rôle relatif de l'anisotropie de forme par rapport à l'anisotropie d'interface pour minimiser la dépendance de l'anisotropie totale à la température d'opération.

Pour bien comprendre l'idée, nous utilisons ici le cas le plus courant d'une jonction tunnel dont la couche de stockage a une forme quasi cylindrique. Dans ce cas et en supposant que la couche de stockage est constituée d'un seul matériau d'aimantation $M_s$, la barrière d'énergie séparant les deux états d'aimantation « vers le haut » et « vers le bas » peut s'exprimer par :

$$\Delta E(T) = A\left[ K_{s1}(T) + K_{s2}(T) - \frac{\mu_0}{4}\left(1 - \frac{3}{1 + 4AR/\sqrt{\pi}}\right)M_s^2(T)L + K_u(T)L \right]$$

Cette expression montre que dès que le rapport de forme de la couche de stockage dépasse

$$AR = \frac{\sqrt{\pi}}{2} \approx 0.89$$ alors le terme d'anisotropie de forme $$-\frac{\mu_0}{4}\left(1 - \frac{3}{1 + 4AR/\sqrt{\pi}}\right)M_s^2 L$$ change de signe pour passer de négatif à positif. En d'autres termes, pour un rapport d'aspect épaisseur/diamètre plus grand que 0.89, l'anisotropie de forme s'ajoute à l'anisotropie perpendiculaire d'interface présente à l'interface barrière tunnel/couche de stockage. Dans cette expression, l'anisotropie $K_u$ d'origine magnétocrystalline ou magnétoélastique est en général négligeable comparativement aux autres termes d'anisotropie, avec les matériaux couramment utilisés comme les alliages à base de Co, de Fe et de Ni déposés par pulvérisation cathodique. La hauteur de barrière $\Delta E(T)$ dépend donc de la température à travers la dépendance en température de l'anisotropie interfaciale $A(K_{s1}(T)+K_{s2}(T))$ et celle de l'anisotropie de forme $$-\frac{\mu_0}{4}\left(1 - \frac{3}{1 + 4AR/\sqrt{\pi}}\right)M_s^2(T)At$$ .

Nous comparons ci-dessous les variations thermiques de ces deux termes d'anisotropie.

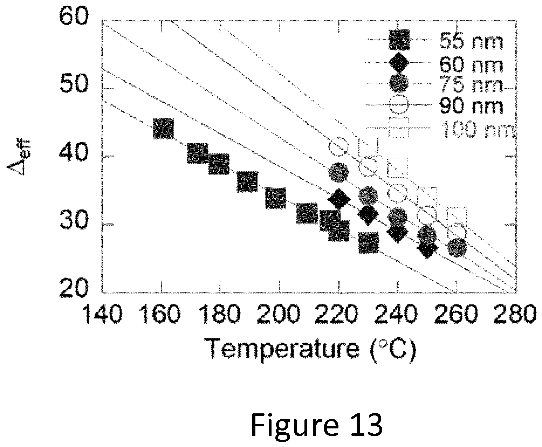

La Figure 13 illustre ceci. Cette figure montre l'évolution en fonction de la température du facteur de stabilité thermique de jonctions tunnel de l'état de l'art jusqu'à 260°C. Pour avoir un taux d'erreur par bit inférieur à $10^{-4}$ pendant

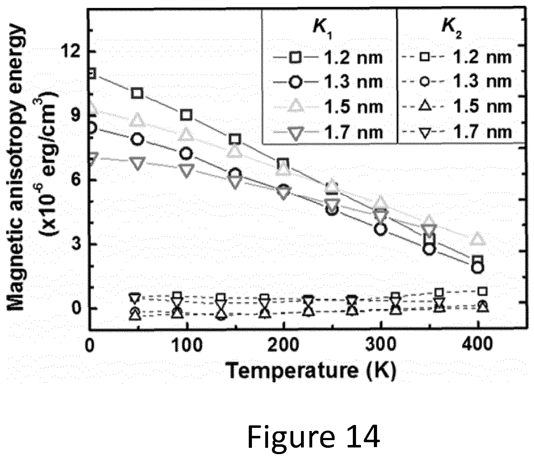

60secondes à 260°C il faut que le facteur de stabilité thermique $\Delta$ satisfasse la relation $$\frac{t}{\tau_0}\exp(-\Delta) < 10^{-4}$$ où t=60s, $\tau_0$=$10^{-9}$s. Ceci impose $\Delta$>34. La Figure 13 montre que ceci n'est satisfait que pour les plus grandes jonctions de diamètre supérieur à 100nm. Par ailleurs, si on extrapole la variation thermique du facteur de stabilité jusqu'à la température ambiante de 25°C, on trouve que celui-ci atteint 115 ce qui est beaucoup plus que requis par bit pour une rétention de 10ans. Ceci implique que le courant d'écriture et la tension d'écriture devront être surdimensionnés à 25°C au prix d'une consommation électrique accrue et d'une endurance à l'écriture réduite pour satisfaire le critère de rétention de 60s à 260°C. La figure 14 montre des variations typiques d'anisotropie interfaciales telles que celles des couches de stockage de jonctions tunnel magnétiques de l'état de l'art. La figure montre en fait les contributions à l'anisotropie interfaciale de premier ordre (uniaxiale en $\sin^2\theta$ , $\theta$ angle entre l'aimantation de la couche de stockage et la normale au plan des couches) et de second ordre (en $\sin^4\theta$) de multicouches W/CoFeB/MgO avec différentes épaisseurs de CoFeB (Kyoung-Min Lee, Jun Woo Choi, Junghyun Sok, and Byoung-Chul Min, Température dependence of the interfacial magnetic anisotropy in W/CoFeB/MgO, AIP Advances 7, 065107 (2017)). La contribution de second ordre est beaucoup plus faible que celle de premier ordre est peut être négligée. Cette figure montre que l'anisotropie interfaciale provenant de l'interface CoFeB/MgO décroit d'environ un facteur 2 entre 300K (27°C) et 400K (127°C) et s'extrapole à zéro bien avant d'atteindre les 260°C. Ceci indique de fortes variations thermiques de cette anisotropie interfaciale comme discuté précédemment en relation avec la Figure 13.

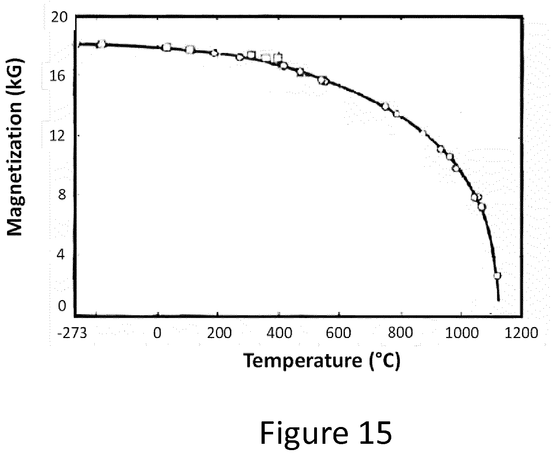

La Figure 15 présente la variation thermique de l'aimantation d'un matériau massif comme le cobalt dont la température de Curie est élevée : 1394K (courbe extraite de Ferromagnetism, Bozorth, Van Nostrand company, Inc). Cette courbe montre que la variation thermique de l'aimantation du cobalt est inférieure à 4% entre 0°C et 260°C. Si la couche de stockage de la STT-MRAM est une couche épaisse à base de cobalt, le terme d'anisotropie de forme

$$-\frac{\mu_0}{4}\left(1 - \frac{3}{1 + 4AR/\sqrt{\pi}}\right)M_s^2(T)AL$$ proportionnel à $$M_s^2(T)$$ ne variera que de 8% ce qui est bien moins que le facteur d'au moins 2 de la variation thermique de l'anisotropie interfaciale.

Pour réduire la variation thermique de l'anisotropie effective, on aura donc tout intérêt à réduire le poids relatif de l'anisotropie interfaciale par rapport à l'anisotropie de volume dans l'anisotropie totale de la couche de stockage. Ceci va à l'opposé des jonctions tunnel perpendiculaires de l'état de l'art dans lesquelles l'anisotropie perpendiculaire provient entièrement de l'anisotropie interfaciale à l'interface MgO/CoFeB. Réduire l'anisotropie interfaciale dans la présente invention pourra être réalisé en particulier en utilisant un alliage riche en cobalt au niveau de l'interface avec la barrière de MgO dans la mesure où il est connu que l'anisotropie perpendiculaire aux interfaces MgO/cobalt est plus faible que celle aux interfaces MgO/Fe (Yang, H. X., M. Chshiev, B. Dieny, J. H. Lee, A. Manchon, and K. H. Shin, 2011, "First principles investigation of the very large perpendicular magnetic anisotropy at Fe|MgO and Co|MgO interfaces," Phys. Rev. B 84, 054401). Par ailleurs le cobalt ayant une température de Curie plus élevée que le fer, cette anisotropie interfaciale restante variera plus faiblement en température que l'anisotropie interfaciale à l'interface MgO/Fe.

En particulier, on peut écrire la barrière d'énergie de façon simplifiée en négligeant l'anisotropie de volume d'origine magnétocrystalline ou magnétoélastique :

$$\Delta E(T) = A\big[K_s(T) + K_v(T)L\big]$$

où $K_s(T)$ regroupe les termes d'anisotropie interfaciale et $K_v(T)$ l'anisotropie volumique de forme proportionnelle à $Ms^2$. Comme le montre les figures 14 et 15, l'anisotropie d'interface décroit en général beaucoup plus vite en température que l'anisotropie de volume.

Typiquement, d'après la Figure 14, l'anisotropie d'interface $K_s$ aux interfaces MgO/FeCoB varie d'environ 50% pour une variation thermique de 100°C autour de la température ambiante. Pour des matériaux comme le Co la variation de $Ms^2$ et donc de $K_v$ n'est que de 6%. Si on veut avoir une variation de la hauteur de barrière $\Delta E$ et donc du courant d'écriture inférieure à 20%, il faudra que la proportion X de l'anisotropie de forme par rapport à l'anisotropie d'interface soit choisie de sorte que 20%>(50%+X *6%)/(1+X) soit X>2.14 que l'on peut approximer à 2. Si on veut que cette variation soit plus faible que 15%, alors il faut augmenter la proportion d'anisotropie de volume de sorte que 15%>(50%+X *6%)/(1+X) soit X>3.89 que l'on peut approximer par 4.

En résumé, si l'anisotropie de forme est deux fois plus grande que l'anisotropie d'interface, en utilisant un matériau pour la couche de stockage à haute température de Curie comme un alliage riche en cobalt, la variation de la hauteur de barrière et donc du courant d'écriture sera de l'ordre de 20% pour une variation de température de 100°C autour de la température ambiante.

Si l'anisotropie de forme est quatre fois plus grande que l'anisotropie d'interface, la variation de la hauteur de barrière sera de 15%. Dans la limite où l'anisotropie de forme serait beaucoup plus grande que l'anisotropie d'interface, cette variation pourrait être réduite à des valeurs de l'ordre de 6% si la couche de stockage a une très haute température de Curie comme le cobalt.

Il est donc possible d'augmenter le poids relatif de l'anisotropie de volume (qui dépend faiblement de la température) par rapport à l'anisotropie d'interface (qui dépend fortement de la température) et de combiner cet effet avec l'optimisation du choix de l'aimantation du matériau principal constitutif de la jonction tunnel et de l'épaisseur de cette dernière pour minimiser les effets de dispersion des propriétés de point mémoire à point mémoire lors de la fabrication d'une puce mémoire, comme il est expliqué plus haut.

## Revendications

**1.** Procédé de fabrication (P) d'une jonction tunnel magnétique à aimantation hors du plan comprenant une couche de stockage (SL) ayant une aimantation commutable entre deux états d'aimantation normale au plan de la couche, les deux états d'aimantation de la couche de stockage (SL) étant séparés par une barrière d'énergie, ladite couche de stockage (SL) présentant une épaisseur comprise entre 0.5 fois et 8 fois un diamètre D d'une section planaire circulaire de la jonction tunnel, la section planaire étant une section de la jonction tunnel selon le plan des couches formant la jonction tunnel, ladite jonction tunnel magnétique possédant un facteur de stabilité thermique $\Delta$ dépendant de la barrière d'énergie et de la température moyenne d'utilisation de la jonction tunnel magnétique T, ledit procédé étant **caractérisé en ce qu'**il comprend les étapes de :

- Calcul de l'épaisseur optimale $L^{opti}$ de la couche de stockage (SL) en utilisant la formule :

$$L^{opti} = \frac{1}{1+\frac{3cD^3K_u}{2b\Delta}}\left[\frac{5D}{4b} - \frac{3cD^3K_s}{4b\Delta} + \sqrt{\left(\frac{5D}{4b} - \frac{3cD^3K_s}{4b\Delta}\right)^2 + \frac{2D^2}{b^2}\left(1 + \frac{3cD^3K_u}{2b\Delta}\right)}\right]$$

$$b = \frac{4}{\sqrt{\pi}}, \quad c = \frac{\pi}{4\,k_B T},$$ Avec Ku l'anisotropie volumique de la couche de stockage (SL), Ks l'anisotropie interfaciale de la couche de stockage (SL) et Kb la constante de Boltzmann ;

- Calcul de l'aimantation moyenne optimale $M_S^{opti}$ de la couche de stockage (SL) en utilisant la formule :

$$M_S^{opti} = \sqrt{\frac{16\,k_B T}{\pi \mu_0}\,\frac{2\Delta(D+b\,L^{opti})^2}{3b(L^{opti})^2 D^3}} \; ;$$

- Choix d'un matériau composant la couche de stockage (SL) possédant une aimantation moyenne suffisamment proche de $M_S^{opti}$ et une épaisseur totale suffisamment proche de $L^{opti}$ pour que la valeur absolue de la dérivée du facteur de stabilité thermique par rapport au diamètre de la section planaire circulaire de la jonction tunnel soit inférieure à $10 nm^{-1}$, la dérivée du facteur de stabilité thermique étant calculée à une température $T_m$, la température $T_m$ étant la température moyenne d'utilisation de la jonction tunnel magnétique.
- Dépôt (D) de l'ensemble des couches ;
- Gravure (RIE) de la couche de stockage (SL) ;
- Gravure (IBE) des autres couches.

**2.** Procédé de fabrication (P) d'une jonction tunnel magnétique à aimantation hors du plan selon la revendication précédente **caractérisé en ce que** la couche de stockage (SL) comprend une couche d'interface en alliage FeCoB et une couche de volume (FM) d'épaisseur $L^{FM}$ et **en ce que** ledit procédé comprend en outre une étape de :

- Calcul de l'épaisseur optimale ($L^{FM\,opti}$) et de l'aimantation optimale ( $M_S^{FM\,opti}$ ) de la couche de volume (FM) en utilisant la formule :

$$\begin{cases} L^{FM\,opti} & = & L^{opti} - L^{FeCoB} \\ M_S^{FM\,opti} & = & \dfrac{M_S^{opti}\,L^{opti} - M_S^{FeCoB}\,L^{FeCoB}}{L^{opti}} \end{cases}$$

Où $L^{FeCoB}$ et $M_S^{FeCoB}$ sont respectivement l'épaisseur et l'aimantation de la couche d'interface.
- Choix d'un matériau composant la couche de volume (FM) de la couche de stockage (SL) possédant une aimantation moyenne suffisamment proche de $M_S^{FM\,opti}$ et une épaisseur suffisamment proche de $L^{FM\,opti}$ pour que la valeur absolue de la dérivée du facteur de stabilité thermique par rapport au diamètre de la section planaire circulaire de la jonction tunnel soit inférieure à $10 nm^{-1}$, la dérivée du facteur de stabilité thermique étant calculée à une température $T_m$, la température $T_m$ étant la température moyenne d'utilisation de la jonction tunnel magnétique.

**3.** Procédé de fabrication (P) selon la revendication précédente **caractérisé en ce que** le diamètre est inférieur à 50nm.

**4.** Procédé de fabrication (P) selon l'une des revendications précédentes **caractérisé en ce que** la couche de stockage (SL) est constituée d'un matériau magnétique homogène.

**5.** Procédé de fabrication (P) selon l'une des revendications 1 à 3 **caractérisé en ce que** la couche de stockage (SL) comprend un ensemble de couches magnétiques et non magnétiques.

**6.** Procédé de fabrication (P) selon la revendication 4 **caractérisé en ce que** la couche de stockage (SL) comprend au moins une couche magnétique contenant un élément amorphisant tel que le bore et une ou plusieurs couches aptes à absorber l'élément amorphisant lors de recuit post-dépôt.

**7.** Procédé de fabrication (P) selon la revendication 4 **caractérisé en ce que** la couche de stockage (SL) comprend au moins deux matériaux magnétiques, dont un premier matériau proche de la barrière tunnel (TB) est apte à fournir une forte magnétorésistance tunnel et un deuxième matériau présente un faible amortissement de Gilbert.

**8.** Procédé de fabrication (P) selon l'une des revendications précédentes **caractérisé en ce que** :

- la barrière tunnel (TB) est réalisée en MgO, AlOx, AIN, SrTiOs, HfOx ou tout autre oxyde ou nitride isolant ;
- la couche de stockage (SL) comporte un empilement de différentes couches comprenant :

  ◦ une couche en alliage de cobalt, fer et bore d'épaisseur entre 1 et 4nm en contact avec la barrière tunnel ;
  ◦ une couche d'un matériau, apte à absorber le bore tel que Ta, Mo ou W au moment des recuits post-dépôt, d'épaisseur 0.2 à 0.4nm,
  ◦ une couche magnétique à faible amortissement de Gilbert.

**9.** Procédé de fabrication (P) selon l'une des revendications précédentes **caractérisé en ce que** :

  ◦ la couche de stockage (SL) présente une épaisseur comprise entre 0.8 et 8 fois le diamètre de la section planaire circulaire de la jonction tunnel
  ◦ la contribution à la barrière d'énergie due à l'anisotropie de forme de la couche de stockage (SL) est au moins deux fois supérieure et de préférence au moins quatre fois supérieure aux contributions à la barrière d'énergie d'origine interfaciale.

## Patentansprüche

**1.** Verfahren zur Herstellung (P) eines magnetischen Tunnelkontakts mit Magnetisierung außerhalb der Ebene, umfassend eine Speicherschicht (SL) mit einer Magnetisierung, die zwischen zwei normalen Magnetisierungszuständen zur Ebene der Schicht umschaltbar ist, wobei die beiden Magnetisierungszustände der Speicherschicht (SL) durch eine Energiebarriere getrennt sind, wobei die Speicherschicht (SL) eine Dicke zwischen 0,5-mal und 8-mal einen Durchmesser D eines kreisförmigen planaren Abschnitts des Tunnelkontakts aufweist, wobei der planare Abschnitt ein Abschnitt des Tunnelkontakts entlang der Ebene der Schichten ist, die den Tunnelkontakt bilden, wobei der magnetische Tunnelkontakt einen thermischen Stabilitätsfaktor A aufweist, der von der Energiebarriere und der mittleren Betriebstemperatur des magnetischen Tunnelkontakts T abhängt, wobei das Verfahren **dadurch gekennzeichnet ist, dass** es die folgenden Schritte umfasst:

- Berechnung der optimalen Dicke $L^{opti}$ der Speicherschicht (SL) mithilfe der Formel:

$$L^{opti} = \frac{1}{1+\frac{3cD^3K_u}{2b\Delta}}\left[\frac{5D}{4b} - \frac{3cD^3K_S}{4b\Delta} + \sqrt{\left(\frac{5D}{4b} - \frac{3cD^3K_S}{4b\Delta}\right)^2 + \frac{2D^2}{b^2}\left(1 + \frac{3cD^3K_u}{2b\Delta}\right)}\right]$$

wobei $b = \frac{4}{\sqrt{\pi}}, \quad c = \frac{\pi}{4k_BT}$, Ku die volumenbezogene Anisotropie der Speicherschicht (SL), Ks die Grenzflächenanisotropie der Speicherschicht (SL) und Kb die Boltzmann-Konstante sind;

- Berechnung der optimalen durchschnittlichen Magnetisierung $M_S^{opti}$ der Speicherschicht (SL) mithilfe der Formel:

$$M_S^{opti} = \sqrt{\frac{16\,k_BT}{\pi\mu_0}\,\frac{2\Delta(D+b\,L^{opti})^2}{3b(L^{opti})^2 D^3}}\,;$$

- Auswahl eines Materials, aus dem die Speicherschicht (SL) besteht, mit einer mittleren Magnetisierung, die

$M_S^{opti}$ ausreichend nahe kommt, und einer Gesamtdicke, die $L^{opti}$ nahe genug kommt, sodass der absolute Wert der Ableitung des thermischen Stabilitätsfaktors in Bezug auf den Durchmesser des kreisförmigen planaren Abschnitts des Tunnelkontakts weniger als 10 nm$^{-1}$ beträgt, wobei die Ableitung des thermischen Stabilitätsfaktors bei einer Temperatur $T_m$ berechnet wird, wobei die Temperatur $T_m$ die mittlere Betriebstemperatur des magnetischen Tunnelkontakts ist.
- Auftragen (D) der gesamten Schichten;
- Ätzen (RIE) der Speicherschicht (SL);
- Ätzen (IBE) der anderen Schichten.

2. Verfahren zur Herstellung (P) eines magnetischen Tunnelkontakts mit Magnetisierung außerhalb der Ebene nach dem vorhergehenden Anspruch, **dadurch gekennzeichnet, dass** die Speicherschicht (SL) eine Grenzflächenschicht aus einer FeCoB-Legierung und eine Volumenschicht (FM) mit der Dicke $L^{FM}$ umfasst und dass das Verfahren außerdem einen Schritt umfasst, bei dem:

- die optimale Dicke ($L^{FM\ opti}$) und die optimale Magnetisierung ( $M_S^{FM\ opti}$ ) der Volumenschicht (FM) mithilfe der Formel berechnet wird:

$$
\begin{cases}
L^{FM\ opti} &= L^{opti} - L^{FeCoB} \\
M_S^{FM\ opti} &= \dfrac{M_S^{opti}\ L^{opti} - M_S^{FeCoB}\ L^{FeCoB}}{L^{opti}}
\end{cases}
$$

Wobei $L^{FeCoB}$ und $M_S^{FeCoB}$ jeweils die Dicke und die Magnetisierung der Grenzflächenschicht sind.
- Auswahl eines Materials, aus dem die Volumenschicht (FM) der Speicherschicht (SL) besteht, mit einer mittleren Magnetisierung, die $M_S^{FM\ opti}$ ausreichend nahe kommt, und einer Dicke, die $L^{FM\ opti}$ nahe genug kommt, sodass der absolute Wert der Ableitung des thermischen Stabilitätsfaktors in Bezug auf den Durchmesser des kreisförmigen planaren Abschnitts des Tunnelkontakts weniger als 10 nm$^{-1}$ beträgt, wobei die Ableitung des thermischen Stabilitätsfaktors bei einer Temperatur $T_m$ berechnet wird, wobei die Temperatur $T_m$ die mittlere Betriebstemperatur des magnetischen Tunnelkontakts ist.

3. Herstellungsverfahren (P) nach dem vorhergehenden Anspruch, **dadurch gekennzeichnet, dass** der Durchmesser kleiner als 50 nm ist.

4. Herstellungsverfahren (P) nach einem der vorhergehenden Ansprüche, **dadurch gekennzeichnet, dass** die Speicherschicht (SL) aus einem homogenen magnetischen Material besteht.

5. Herstellungsverfahren (P) nach einem der Ansprüche 1 bis 3, **dadurch gekennzeichnet, dass** die Speicherschicht (SL) eine Reihe von magnetischen und nichtmagnetischen Schichten umfasst.

6. Herstellungsverfahren (P) nach Anspruch 4, **dadurch gekennzeichnet, dass** die Speicherschicht (SL) mindestens eine magnetische Schicht, die ein amorphisierendes Element wie Bor enthält, und eine oder mehrere Schichten umfasst, die geeignet sind, das amorphisierende Element beim Glühen nach dem Auftragen zu absorbieren.

7. Herstellungsverfahren (P) nach Anspruch 4, **dadurch gekennzeichnet, dass** die Speicherschicht (SL) mindestens zwei magnetische Materialien umfasst, von denen ein erstes Material nahe der Tunnelbarriere (TB) geeignet ist, einen hohen Tunnelmagnetowiderstand zu liefern, und ein zweites Material eine geringe Gilbert-Dämpfung aufweist.

8. Herstellungsverfahren (P) nach einem der vorhergehenden Ansprüche, **dadurch gekennzeichnet, dass**:

- die Tunnelbarriere (TB) aus MgO, AlOx, AlN, SrTiOs, HfOx oder einem anderen isolierenden Oxid oder Nitrid hergestellt ist;
- die Speicherschicht (SL) eine Schichtung aus verschiedenen Schichten aufweist, die Folgendes umfasst:

o eine Schicht aus einer Kobalt-, Eisen- und Borlegierung mit einer Dicke zwischen 1 und 4 nm, die mit der Tunnelbarriere in Kontakt steht;
o eine Schicht aus einem Material, das in der Lage ist, beim Glühen nach dem Auftragen Bor zu absorbieren, wie z. B. Ta, Mo oder W, mit einer Dicke von 0,2 bis 0,4 nm,
o eine magnetische Schicht mit geringer Gilbert-Dämpfung.

9. Herstellungsverfahren (P) nach einem der vorhergehenden Ansprüche, **dadurch gekennzeichnet, dass**:

o die Speicherschicht (SL) eine Dicke zwischen dem 0,8- und 8-fachen des Durchmessers des kreisförmigen planaren Abschnitts des Tunnelkontakts aufweist;
o der Beitrag zur Energiebarriere aufgrund der Formanisotropie der Speicherschicht (SL) mindestens doppelt so groß und vorzugsweise mindestens viermal so groß ist wie die Beiträge zur Energiebarriere, die auf Grenzflächen zurückzuführen sind.

**Claims**

1. Method for manufacturing (P) a magnetic tunnel junction with out-of-plane magnetisation including a storage layer (SL) having a magnetisation switchable between two magnetisation states normal to the plane of the layer, the two magnetisation states of the storage layer (SL) being separated by an energy barrier, said storage layer (SL) having a thickness comprised between 0.5 times and 8 times a diameter D of a circular planar section of the tunnel junction, said planar section being a section of the tunnel junction about the plan of layers forming the tunnel junction, said magnetic tunnel junction having a thermal stability factor $\Delta$ dependent on the energy barrier and on the average temperature of use of the magnetic tunnel junction T, said method comprising:

- calculating the optimal thickness $L^{opti}$ of the storage (SL) layer using the formula:

$$L^{opti} = \cfrac{1}{1 + \cfrac{3cD^3K_u}{2b\Delta}} \left[ \frac{5D}{4b} - \frac{3cD^3K_S}{4b\Delta} + \sqrt{\left(\frac{5D}{4b} - \frac{3cD^3K_S}{4b\Delta}\right)^2 + \frac{2D^2}{b^2}\left(1 + \frac{3cD^3K_u}{2b\Delta}\right)} \right]$$

With $b = \frac{4}{\sqrt{\pi}}, \quad c = \frac{\pi}{4\,k_B T}$, Ku the volume anisotropy of the storage layer (SL), Ks the interfacial anisotropy of the storage layer (SL) and Kb Boltzmann's constant;
- Calculating the optimal average magnetisation $Ms^{opti}$ of the storage layer using the formula:

$$M_S^{opti} = \sqrt{\frac{16\,k_B T}{\pi\mu_0}\frac{2\Delta(D + b\,L^{opti})^2}{3b(L^{opti})^2 D^3}}$$

- Choosing a material composing the storage layer (SL) having an average magnetisation sufficiently close to $M_S^{opti}$ and a total thickness sufficiently close to $L^{opti}$ so that the absolute value of the derivative of the thermal stability factor compared to the diameter of a planar section of the magnetic tunnel junction is less than 10 nm$^{-1}$, the derivative of the thermal stability factor being calculated at a temperature $T_m$, the temperature $T_m$ being the average temperature of use of the magnetic tunnel junction.
- Depositing (D) all of the layers;
- Etching (RIE) the storage layer (SL);
- Etching (IBE) the other layers.

2. Method for manufacturing (P) a magnetic tunnel junction with out-of-plane magnetisation according to the preceding claim **characterized in that** the storage layer (SL) includes an interface layer made of FeCoB alloy and a volume layer (FM) of thickness $L^{FM}$ and wherein method further includes:

- calculating the optimal thickness ($L^{FM\ opti}$) and the optimal magnetisation ($M_S^{FM\ opti}$) of the volume layer using the formula:

$$\begin{cases} L^{FM\ opti} & = & L^{opti} - L^{FeCoB} \\ M_S^{FM\ opti} & = & \dfrac{M_S^{opti}\ L^{opti} - M_S^{FeCoB}\ L^{FeCoB}}{L^{opti}} \end{cases}$$

where $L^{FeCoB}$ and $M_S^{FeCoB}$ are respectively the thickness and the magnetisation of the interface layer.
- Choosing a material composing the volume layer (FM) of the storage layer (SL) having an average magnetisation sufficiently close to $M_S^{FM\ opti}$ and a thickness sufficiently close to $L^{FM\ opti}$ so that the absolute value of the derivative of the thermal stability factor compared to a diameter of the circular planar section of the tunnel junction is less than 10 nm$^{-1}$, the derivative of the thermal stability factor being calculated at a temperature $T_m$, the temperature $T_m$ being the average temperature of use of the magnetic tunnel junction.

3. Method for manufacturing (P) according to the preceding claim **characterized in that** the diameter in less than 50 nm.

4. Method for manufacturing (P) according to any of the preceding claims **characterized in that** the storage layer (SL) consists of a homogeneous magnetic material.

5. Method for manufacturing (P) according to any of the claims 1 to 3 **characterized in that** the storage layer (SL) comprises a set of magnetic and non-magnetic layers.

6. Method for manufacturing (P) according to the claims 4 **characterized in that** the storage layer (SL) comprises at least a magnetic layer comprising an amorphising element such as Bore and one or more layers capable of absorb the amorphising element during post-deposition annealing.

7. Method for manufacturing (P) according to the claims 4 **characterized in that** the storage layer (SL) comprises at least two magnetic materials, of which a first material close to the tunnel barrier (TB) is capable of providing a high tunnel magnetoresistance and a second material has a low Gilbert damping.

8. Method for manufacturing (P) according to one of the preceding claims, **characterized in that**:

- the tunnel barrier (TB) is made of MgO, AlOx, AlN, SrTiO$_3$, HfOx or any other insulating oxide or nitride;
- the storage layer (SL) comprises a stack of different layers including:

o a cobalt, iron and boron alloy layer between 1 and 4 nm thick in contact with the tunnel barrier;
o a layer of a material capable of absorbing boron, such as Ta, Mo or W during post-deposit annealing, with a thickness of 0.2 to 0.4 nm,
o a magnetic layer with low Gilbert damping.

9. Method for manufacturing (P) according to one of the preceding claims, **characterized in that**:

o the storage layer (SL) has a thickness of between 0.8 and 8 times the diameter of the circular planar section of the tunnel junction;
o the contribution to the energy barrier due to the shape anisotropy of the storage layer (SL) is at least twice and preferably at least four times greater than the contributions to the energy barrier of interfacial origin.

Figure 1

Figure 2

Figure 3

Figure 4

PSA-MRAM-2

T2

FM

SL ⎰ TR

I

TB
RL
TS

SAF

RKKY

M

T1

Figure 5

Figure 6

Figure 7

Figure 8

a)  b)  c)  d)  e)

P ➔ D ➔ RIE ➔ IBE

Figure 9

Figure 10a

T1

M

RKKY

TS

RL

TB

SAF

I

TR

FM

SL

T3

T2

PSA-SOT - B

LM

Figure 10b

Figure 11

Figure 12

Figure 13

Figure 14

Figure 15

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 8247093 B2
- US 8513944 B2
- US 20150036415 A1

**Littérature non-brevet citée dans la description**

- **TAKAYUKI KAWAHARA.** Challenges toward gigabit-scale spin-transfer torque random access memory and beyond for normally off, green information technology infrastructure. *J. Appl. Phys.,* 2011, vol. 109, 07D325
- **SLONCZEWSKI, J. C.** Current driven excitations of magnetic multilayers. *J. Magn. Magn. Mater.,* 1996, vol. 159, L1-L7
- **BERGER, L.** Emission of spin waves by a magnetic multilayer traversed by a current. *Phys. Rev. B,* 1996, vol. 54, 4828-4830
- **KATINE, J.A. ; F. J. ALBERT ; R. A. BUHRMAN ; E. B. MYERS ; D. C. RALPH.** Current-driven magnetization reversai and spin-wave excitations in Co /Cu /Co pillars. *Phys. Rev. Lett.,* 2000, vol. 84, 3149-3152
- Magnetic Random Access Memory. **B.DIENY ; L.PREJBEANU.** Introduction to Magnetic Random Access Memory. IEEE Press, J.Wiley
- **APALKOV, D. ; B. DIENY ; J. M. SLAUGHTER.** Magnetoresistive Random Access Memory. *Proceedings of the IEEE,* 2016, vol. 104, 1796-1830
- **IKEDA, S. ; K. MIURA ; H. YAMAMOTO ; K. MIZUNUMA ; H. D. GAN ; M. ENDO ; S. KANAI ; J. HAYAKAWA ; F. MATSUKURA ; H. OHNO.** A perpendicular-anisotropy CoFeB-MgO magnetic tunnel junction. *Nature Mater.,* 2010, vol. 9, 721-724
- **YANG, H. X. ; M. CHSHIEV ; B. DIENY ; J. H. LEE ; A. MANCHON ; K. H. SHIN.** First principles investigation of the very large perpendicular magnetic anisotropy at Fe|MgO and Co|MgO interfaces. *Phys. Rev. B,* 2011, vol. 84, 054401
- **SATO, H. ; T. YAMAMOTO ; M. YAMANOUCHI ; S. IKEDA ; S. FUKAMI ; K. KINOSHITA ; F. MATSUKURA ; N. KASAI ; H. OHNO.** Comprehensive study of CoFeB-MgO magnetic tunnel junction characteristics with single- and double-interface scaling down to 1X nm. *Proceedings of the International Electron Devices Meeting (IEDM), San Francisco,* 2014, 33.2.1-33.2.4
- **M. SATO ; Y. ISHII.** *J. Appl. Phys.,* 1989, vol. 60, 983
- **DU-XING CHEN ; JAMES A. BRUG ; RONALD B. GOLDFARB.** Demagnetizing Factors for Cylinders. *IEEE Trans.Mag.,* 1991, vol. 4, 3601
- **M BELEGGIA ; M DE GRAEF ; Y T MILLEV ; D A GOODE ; G ROWLANDS.** Demagnetization factors for elliptic cylinders. *J. Phys. D: Appl. Phys.,* 2005, vol. 38, 3333
- **SUN, J. Z.** Spin-current interaction with a monodomain magnetic body: A model study. *Phys. Rev. B,* 2000, vol. 62, 570-578
- **K. WATANABE ; B. JINNAI ; S. FUKAMI ; H. SATO ; H. OHNO.** Shape anisotropy revisited in single-digit nanometer magnetic tunnel junctions. *Nature Communications,* 2018, vol. 9, 663
- **KYOUNG-MIN LEE et al.** Température dependence of the interfacial magnetic anisotropy in W/CoFeB/MgO. *AIP Advances,* 2017, vol. 7, 065107
- **M.T.MONECK ; J.G.ZHU.** *NSTI-Nanotech,* 2011
- **Y.SHIOTA ; T.NOZAKI ; F.BONELL ; S.MURAKAMI ; T.SHINJO ; Y. SUZUKI.** Induction of cohérent magnetization switching in a few atomic layers of FeCo using voltage pulses. *Nat.Mat.,* 2012, vol. 11, 39
- **KYOUNG-MIN LEE ; JUN WOO CHOI ; JUNGHYUN SOK ; BYOUNG-CHUL MIN.** Température dependence of the interfacial magnetic anisotropy in W/CoFeB/MgO. *AIP Advances,* 2017, vol. 7, 065107